# EUROPÄISCHE PATENTANMELDUNG

(11) **EP 4 340 392 A1**
(43) Veröffentlichungstag der Anmeldung: **20.03.2024**
(21) Anmeldenummer: 23197555.8
(22) Anmeldetag: 14.09.2023
(51) Int. Cl.: H04R 9/02, B81B 3/00, B81C 1/00, H04R 15/00, H04R 17/00, H04R 19/00, H04R 23/00

(54) **MEMS, VERFAHREN ZUM HERSTELLEN EINES MEMS UND VERFAHREN ZUM AUSLEGEN EINES MEMS**

(30) Priorität: 15.09.2022 DE 102022209706
(71) Anmelder: Fraunhofer-Gesellschaft zur Förderung der angewandten Forschung e.V., 80686 München (DE)
(72) Erfinder: Melnikov, Anton, 01109 Dresden (DE); Amelung, Jörg, 01109 Dresden (DE); Kaiser, Bert, 01109 Dresden (DE); Stolz, Michael, 01109 Dresden (DE)
(74) Vertreter: König, Andreas Rudolf

(57) **Zusammenfassung**

Ein MEMS umfasst ein Substrat und eine in dem Substrat angeordnete Kavität. In der Kavität ist ein bewegliches Element angeordnet, das ausgebildet ist, um mit einem in der Kavität angeordneten Fluid zu interagieren, wobei eine Bewegung des Fluids und eine Bewegung des beweglichen Elements kausal zusammenhängen. Eine erste Öffnung, die die Kavität mit einer Umgebung des Substrats verbindet, bewirkt einen ersten Phasenversatz einer ersten mit der Bewegung des beweglichen Elements kausal zusammenhängenden periodischen Oszillation beim Durchqueren der ersten Öffnung. Eine zweite Öffnung, die die Kavität mit der Umgebung des Substrats verbindet, bewirkt einen von dem ersten Phasenversatz verschiedenen zweiten Phasenversatz einer zweiten mit der Bewegung des beweglichen Elements kausal zusammenhängenden periodischen Oszillation beim Durchqueren der zweiten Öffnung.

## Beschreibung

Die vorliegende Erfindung bezieht sich auf ein MEMS zum Erzeugen periodischer Oszillationen in einem Fluid, möglicherweise eine akustische Welle, auf ein Array mit mehreren MEMS, auf eine Vorrichtung mit einem hierin beschriebenen MEMS oder Array sowie auf Verfahren, die ausgelegt sind, um ein MEMS herzustellen und/oder um ein MEMS auszulegen. Die vorliegende Erfindung bezieht sich insbesondere auf phasenversetzte Luftöffnungen.

MEMS-basierte Schallwandler oder Ultraschallwandler sind für viele Anwendungen eine Alternative zu piezobasierten und elektrodynamischen Wandlern. Durch laterale Bewegungen der Mikrobalken im Chip können Schallwellen erzeugt werden, welche durch eine geeignete Schallführung nach außen geführt werden, damit kein akustischer Kurzschluss erzeugt wird und die akustische Energie verwendet werden kann. Dabei kann zwischen einer positiven und einer negativen Seite unterschieden werden, die 180° versetzt zueinander sind, wodurch sich eine Dipolabstrahlungscharakteristik in der Abstrahlung ausbildet. Die Energie der Rückseite des Wandlers wird in der Regel nicht verwendet und in ein geschlossenes Rückvolumen abgeleitet. Aufgrund des Rückvolumens wird jedoch zusätzliche Energie für die Kompression der Luft in dem geschlossenen Volumen aufgewendet. Außerdem benötigt das Rückvolumen einen Bauraum, der die Größe des Wandlers selbst um ein Vielfaches übersteigt.

Wünschenswert wären demnach kleinbauende und effiziente MEMS zur Bereitstellung periodischer Oszillationen in einem Fluid.

Eine Aufgabe der vorliegenden Erfindung besteht darin, kleinbauende und effiziente MEMS zur Bereitstellung periodischer Oszillationen in einem Fluid, ein Array mit mehreren solcher MEMS, eine Vorrichtung mit einem MEMS oder einem Array von MEMS, ein Verfahren zum Herstellen eines MEMS und ein Verfahren zum Auslegen eines MEMS bereitzustellen, die in kleinbauenden und effizienten MEMS resultieren.

Diese Aufgabe wird durch den Gegenstand der unabhängigen Patentansprüche gelöst.

Ein Kerngedanke der vorliegenden Erfindung besteht darin, erkannt zu haben, dass eine Nutzung der in anderen Fällen in das Rückvolumen abgestrahlten Energie einer periodischen Oszillation auch mit einem Phasenversatz gegenüber der anderen periodischen Oszillation nutzbar gemacht werden kann und so auf den Energieverlust durch Abführen der akustischen Energie in das Rückvolumen, für die Kompression von Fluid in dem Rückvolumen und darüber hinaus der Bauraum für das Rückvolumen reduziert oder gar eingespart werden kann, womit ein MEMS sowohl im Hinblick auf die aktive Seite vergleichsweise kleiner gebaut werden kann als auch Bauraum, etwa für das Rückvolumen, eingespart werden kann. Dadurch können sowohl effiziente als auch kleinbauende MEMS erhalten werden.

Gemäß einem Ausführungsbeispiel umfasst ein MEMS ein Substrat und eine in dem Substrat angeordnete Kavität. In der Kavität ist ein bewegliches Element angeordnet, das ausgebildet ist, um mit einem in der Kavität angeordneten Fluid zu interagieren, wobei eine Bewegung des Fluids und eine Bewegung des beweglichen Elements kausal zusammenhängen. Das MEMS umfasst eine erste Öffnung, die die Kavität mit einer Umgebung des Substrats verbindet und die ausgebildet ist, um einen ersten Phasenversatz einer ersten mit der Bewegung des beweglichen Elements kausal zusammenhängenden periodischen Oszillation beim Durchqueren der ersten Öffnung zu bewirken. Das MEMS umfasst eine zweite Öffnung, die die Kavität mit der Umgebung des Substrats verbindet und die ausgebildet ist, um einen von dem ersten Phasenversatz verschiedenen zweiten Phasenversatz einer zweiten mit der Bewegung des beweglichen Elements kausal zusammenhängenden periodischen Oszillation beim Durchqueren der zweiten Öffnung zu bewirken. Durch die Nutzung der unterschiedlichen Phasenversätze kann eine gegenseitige Auslöschung beider periodischer Oszillationen in der Umgebung reduziert oder vermieden werden und somit beide Energieeinträge nutzbar gemacht werden, was kleinbauende MEMS und energieeffiziente MEMS ermöglicht.

Gemäß einem Ausführungsbeispiel ist das bewegliche Element in-plane in einer Ebene parallel zu einer Substratebene des Substrats beweglich angeordnet. Die in-plane Aktuatorik ermöglicht eine effiziente Erzeugung periodischer Oszillationen.

Gemäß einem Ausführungsbeispiel ist das MEMS ausgebildet, um den ersten Phasenversatz und den zweiten Phasenversatz basierend auf einem thermoviskosen Effekt bereitzustellen. Vorteilhaft daran ist, dass ein derartiger Effekt problemlos in einem MEMS erzeugbar ist.

Gemäß einem Ausführungsbeispiel unterscheidet sich die erste Öffnung von der zweiten Öffnung in zumindest einem aus einem Öffnungsquerschnitt der Öffnung; einem Verlauf des Öffnungsquerschnitts entlang einer Richtung durch das Substrat; und einer Tiefe in dem Substrat, um den voneinander verschiedenen Phasenversatz zu erzeugen. Diese Unterschiede können dabei statisch oder dynamisch sein, etwa durch Verwendung einer Aktuatorik, was eine zusätzliche Einstellmöglichkeit bietet.

Gemäß einem Ausführungsbeispiel sind die erste Öffnung und die zweite Öffnung ausgebildet, um die erste periodische Oszillation, die den ersten Phasenversatz aufweist, und die zweite periodische Oszillation, die den zweiten Phasenversatz aufweist, in ein gemeinsames Volumen abzugeben, in welchem sich die erste periodische Oszillation und die zweite periodische Oszillation überlagern. Der entsprechende Energieeintrag kann sich dort aufsummieren, was eine sehr effiziente Erzeugung periodischer Oszillationen ermöglicht.

Gemäß einem Ausführungsbeispiel wird bei einer Überlagerung der ersten periodischen Oszillation und der zweiten periodischen Oszillation, insbesondere in dem gemeinsamen Volumen, ein akustischer Kurzschluss vermieden und die Überlagerung ist frei von einem akustischen Kurzschluss. Eine derartige Vermeidung eines akustischen Kurzschlusses ermöglicht eine Vermeidung oder ein Einsparen eines Rückvolumens einer Lautsprecherkonfiguration.

Gemäß einem Ausführungsbeispiel sind die erste Öffnung und die zweite Öffnung an einer gleichen Seite des Substrats angeordnet, was eine direkte Abstrahlung in ein gemeinsames Volumen ermöglichen kann.

Gemäß einem Ausführungsbeispiel weist das bewegliche Element eine erste Seite und eine gegenüberliegende zweite Seite auf. Das bewegliche Element ist ausgebildet, um bei einer mit der Bewegung des beweglichen Element assoziierten Verdrängung oder Verschiebung oder Bewegung des Fluids mit der ersten Seite die erste periodische Oszillation zu erzeugen oder auszulösen und das Fluid durch die erste Öffnung zu bewegen. Bei einer mit der Bewegung des beweglichen Elements assoziierten Verdrängung, Verschiebung oder Bewegung des Fluids mit der zweiten Seite wird die zweite periodische Oszillation erzeugt oder ausgelöst und das Fluid durch die zweite Öffnung bewegt. Hierdurch kann insbesondere bei periodischer Ansteuerung des beweglichen Elements, etwa in Resonanz desselben, eine gleiche Frequenz der ersten periodischen Oszillation und der zweiten periodischen Oszillation erzeugt werden, die sich beispielsweise durch die unterschiedlichen Phasenversätze gut trennen lassen und bei der gemeinsamen Frequenz überlagern können.

Gemäß einem Ausführungsbeispiel ist eine Schallführung mit der ersten Seite durch die erste Öffnung von einer Schallführung mit der zweiten Seite durch die zweite Öffnung basierend auf dem ersten Phasenversatz und dem zweiten Phasenversatz voneinander verschieden, womit besonders effizient ein akustischer Kurzschluss vermieden werden kann.

Gemäß einem Ausführungsbeispiel weist der erste Phasenversatz eine erste Korrelation zu der Bewegung des beweglichen Elements auf und der zweite Phasenversatz weist eine zweite Korrelation zu der Bewegung des beweglichen Elements auf. Der erste Phasenversatz und der zweite Phasenversatz weisen eine Beziehung zueinander auf, um die erste periodische Oszillation mit dem ersten Phasenversatz und die zweite periodische Oszillation mit dem zweiten Phasenversatz mit einer innerhalb eines Toleranzbereichs übereinstimmenden Phase in die Umgebung abzugeben. Dies ermöglicht einen hohen Wirkungsgrad der überlagerten Oszillationen.

Gemäß einem hierzu alternativen Ausführungsbeispiel weist der erste Phasenversatz eine erste Korrelation zu der Bewegung des beweglichen Elements auf und der zweite Phasenversatz eine zweite Korrelation zu der Bewegung des beweglichen Elements. Der erste Phasenversatz und der zweite Phasenversatz weisen eine Beziehung zueinander auf, um die erste periodische Oszillation mit dem ersten Phasenversatz und die zweite periodische Oszillation mit dem zweiten Phasenversatz mit einer durch eine Überlagerung der ersten periodischen Oszillation und der zweiten periodischen Oszillation erhaltene Richtcharakteristik in die Umgebung abzugeben. Dies ermöglicht eine Beibehaltung eines bewussten, ggf. geringfügigen Phasenversatzes am Ort der Überlagerung, so dass der Phasenversatz als erhaltene Richtcharakteristik genutzt werden kann. Dies ermöglicht zusätzliche Freiheitsgrade bei der Nutzung des MEMS.

Gemäß einem Ausführungsbeispiel ist die Richtcharakteristik bezogen auf eine Oberflächennormale des Substrats und eine Richtung der ersten Öffnung und/oder der zweiten Öffnung schräg angeordnet.

Gemäß einem Ausführungsbeispiel weist das MEMS eine Phasenanpassungseinrichtung auf, die ausgebildet ist, um ein Ansteuersignal zu empfangen, und um den ersten Phasenversatz und/oder den zweiten Phasenversatz basierend auf dem Ansteuersignal anzupassen. Dies ermöglicht eine hohe Variabilität des Betriebs des MEMS.

Gemäß einem Ausführungsbeispiel ist die Phasenanpassungseinrichtung ausgebildet, um eine Größe der ersten Öffnung zu verändern, um den ersten Phasenversatz anzupassen und/oder um eine Größe der zweiten Öffnung zu verändern, um den zweiten Phasenversatz anzupassen. Obwohl hierin beschriebene Ausführungsbeispiele nicht ausschließen, den Phasenversatz durch Einsatz thermischer Energie zum lokalen Erwärmen und/oder Kühlen die Phasenverzögerung anzupassen und/oder um durch eine lokale Druckerhöhung die Phasenverzögerung in zumindest einer der Öffnungen anzupassen, bietet die Anpassung einer Größe der Öffnung eine einfache Möglichkeit zur Anpassung des Phasenversatzes.

Gemäß einem Ausführungsbeispiel umfasst ein Array eine Mehrzahl hierin beschriebener MEMS, die gleich oder verschieden voneinander gebildet werden können. Dies ermöglicht die Erzeugung starker Signale mit einer speziellen Frequenz und/oder eine breitbandige Erzeugung periodischer Oszillationen.

Gemäß einem Ausführungsbeispiel ist das Array ausgebildet, um die ersten phasenversetzten periodischen Oszillationen mit einer gemeinsamen Richtcharakteristik auszusenden und/oder um die zweiten periodischen Oszillationen mit einer gemeinsamen Richtcharakteristik auszusenden. Dies ermöglicht eine effiziente Nutzung der MEMS.

Gemäß einem Ausführungsbeispiel ist das Array ausgebildet, um die ersten phasenversetzten periodischen Oszillationen mit einer gemeinsamen Richtcharakteristik auszusenden, die bezogen auf eine Oberflächennormale des Substrats und eine Richtung der ersten Öffnungen der Mehrzahl von MEMS schräg angeordnet ist und bei dem die ersten Öffnungen der Mehrzahl von MEMS für einen voneinander verschiedenen Phasenversatz eingerichtet sind. Alternativ oder zusätzlich ist das Array ausgebildet, um die zweiten phasenversetzten periodischen Oszillationen mit einer gemeinsamen Richtcharakteristik auszusenden, die bezogen auf eine Oberflächennormale des Substrats und eine Richtung der zweiten Öffnungen der Mehrzahl von MEMS schräg angeordnet ist und bei dem die zweiten Öffnungen der Mehrzahl on MEMS für einen voneinander verschiedenen Phasenversatz eingerichtet sind. Da die unterschiedlichen Öffnungen, die zur gemeinsamen Richtcharakteristik beitragen, an unterschiedlichen Orten angeordnet sind, können durch entsprechende Anpassungen der Phasenverschiebung bzw. des Phasenversatzes diese örtlichen Unterschiede ausgeglichen werden, in Analogie zu einem Antennenarray, bei dem örtlich unterschiedlich positionierte Antennen trotzdem zu einer gemeinsamen Richtcharakteristik einer Funkwelle beitragen können.

Gemäß einem Ausführungsbeispiel wird ein Array bereitgestellt, bei dem die Mehrzahl an ersten Öffnungen einen jeweiligen Phasenversatz der ersten periodischen Oszillationen bereitstellen und eine Überlagerung der phasenversetzten ersten periodischen Oszillationen auf einen gemeinsamen ersten Fokusbereich gerichtet ist. Alternativ oder zusätzlich stellt die Mehrzahl an zweiten Öffnungen einen jeweiligen Phasenversatz der zweiten periodischen Oszillationen bereit und eine Überlagerung phasenversetzter zweiter periodischer Oszillationen ist auf einen gemeinsamen zweiten Fokusbereich gerichtet.

Gemäß einer bevorzugten Ausführungsform ist der erste Fokusbereich und der zweite Fokusbereich räumlich benachbart zueinander oder überlappend, was in einer Vergrößerung des Fokusbereichs gegenüber einem einzigen Fokusbereich resultieren kann bzw. einer Verstärkung der periodischen Oszillation in dem überlappenden Fokusbereich resultieren kann.

Gemäß einem Ausführungsbeispiel weist das Array eine Steuerungseinrichtung auf, die ausgebildet ist, um ein Anpassungssignal bereitzustellen. Das Array umfasst eine Phasenanpassungseinrichtung, die ausgebildet ist, um das Ansteuersignal zu empfangen und um zumindest einen ersten Phasenversatz zumindest einer der ersten Öffnungen und/oder zumindest einen zweiten Phasenversatz zumindest einer der zweiten Öffnungen basierend auf dem Ansteuersignal anzupassen. Dies ermöglicht die Variation eines von dem Array erhaltenen Ausgangssignals.

Gemäß einem Ausführungsbeispiel ist die Steuerungseinrichtung ausgebildet, um den Phasenversatz der zumindest einen zweiten Öffnung unabhängig von einem Phasenversatz der zumindest einen ersten Öffnung und/oder um den Phasenversatz der zumindest einen ersten Öffnung unabhängig von einem Phasenversatz der zumindest einen zweiten Öffnung zu steuern. Dies ermöglicht eine hohe Präzision in der Ansteuerung des Arrays.

Gemäß einem Ausführungsbeispiel ist die Steuerungseinrichtung ausgebildet, um die Phasenanpassungseinrichtung basierend auf dem Ansteuersignal zu steuern, um für eine Überlagerung der phasenversetzten ersten periodischen Oszillationen und/oder für eine Überlagerung der phasenversetzten zweiten periodischen Oszillationen zumindest eines aus einer Änderung einer Keule einer Richtcharakteristik der Überlagerung; einer Kompensation für eine breitbandige Anpassung; und einer Modulation eines Signals auf eine Frequenz der ersten und/oder zweiten phasenversetzten periodischen Oszillationen zu erzeugen.

Gemäß einem Ausführungsbeispiel wird eine Vorrichtung bereitgestellt, die zumindest ein MEMS oder ein Array in Übereinstimmung mit hierin beschriebenen Ausführungsbeispielen umfasst. Die erste Öffnung und die zweite Öffnung des MEMS sind mit demselben fluidischen Volumen verbunden.

Gemäß einem Ausführungsbeispiel ist das MEMS als Lautsprecher konfiguriert und ohne Rückvolumen ausgebildet.

Gemäß einem Ausführungsbeispiel umfasst ein Verfahren zum Herstellen eines MEMS ein Bereitstellen eines Substrats mit einer in dem Substrat angeordneten Kavität und ein Anordnen eines beweglichen Elements in der Kavität, so dass das bewegliche Element ausgebildet ist, um mit einem in der Kavität angeordneten Fluid zu interagieren, so dass eine Bewegung des Fluids und eine Bewegung des beweglichen Elements kausal zusammenhängen. Das Verfahren umfasst ein Bereitstellen einer ersten Öffnung, die die Kavität mit einer Umgebung des Substrats verbindet, so dass die erste Öffnung einen ersten Phasenversatz einer ersten mit der Bewegung des beweglichen Elements kausal zusammenhängenden periodischen Oszillation beim Durchqueren der ersten Öffnung bewirkt und ein Bereitstellen einer zweiten Öffnung, die die Kavität mit der Umgebung des Substrats verbindet, so dass die zweite Öffnung einen von dem ersten Phasenversatz verschiedenen zweiten Phasenversatz einer zweiten mit der Bewegung des beweglichen Elements kausal zusammenhängenden periodischen Oszillation beim Durchqueren der zweiten Welle bewirkt.

Gemäß einem Ausführungsbeispiel umfasst ein Verfahren zum Auslegen eines MEMS ein Bestimmen einer ersten Eigenschaft einer ersten Öffnung in einem Substrat zum Erhalt des ersten Phasenversatzes und einer zweiten Eigenschaft der zweiten Öffnung zum Erhalt des zweiten Phasenversatzes basierend auf einer vorbestimmten Phasenbeziehung zwischen dem ersten Phasenversatz und dem zweiten Phasenversatz. Das Verfahren umfasst ferner ein Herstellen des MEMS mit der ersten Eigenschaft und der zweiten Eigenschaft.

Weitere bevorzugte Ausführungsformen der vorliegenden Erfindung sind Gegenstand abhängiger Patentansprüche.

Bevorzugte Ausführungsformen der vorliegenden Erfindung werden nachfolgend Bezug nehmend auf die beiliegenden Zeichnungen erläutert. Dabei zeigen:
- Fig. 1a: eine schematische Seitenschnittansicht eines MEMS gemäß einem Ausführungsbeispiel mit einem in-plane beweglichen Element;
- Fig. 1b: eine schematische Seitenschnittansicht eines MEMS gemäß einem Ausführungsbeispiel mit einem out-of-plane beweglichen Element
- Fig. 2: eine schematische Seitenschnittansicht eines MEMS gemäß einem Ausführungsbeispiel, bei dem das Substrat mehrschichtig gebildet ist;
- Fig. 3: ein schematisches Blockschaltbild eines MEMS gemäß einem Ausführungsbeispiel, bei dem eine Kavität wird durch zwei bewegliche Elemente in insgesamt drei Teilkavitäten unterteilt ist;
- Fig. 4: eine schematische Seitenschnittansicht eines MEMS gemäß einem Ausführungsbeispiel, bei dem Öffnungen der Kavität an einer gleichen Seite des Substrats angeordnet sind;
- Fig. 5: eine schematische Seitenschnittansicht eines Arrays gemäß einem Ausführungsbeispiel;
- Fig. 6a: eine schematische Seitenschnittansicht eines Arrays gemäß einem Ausführungsbeispiel, bei dem die angeordneten MEMS voneinander verschieden gebildet sind;
- Fig. 6b: eine schematische Seitenschnittansicht eines Arrays gemäß einem Ausführungsbeispiel, bei dem unter Auslegung der jeweiligen Phasenverschiebungen voneinander abweichende Ausbreitungsrichtungen der MEMS-Bereiche erhalten werden können;
- Fig. 6c: eine schematische Seitenschnittansicht eines Arrays gemäß einem Ausführungsbeispiel, bei dem die jeweiligen zweiten Öffnungen der MEMS zu unterschiedlichen Raumrichtungen ausgerichtet sind;
- Fig. 7: eine schematische Seitenschnittansicht eines Arrays gemäß einem Ausführungsbeispiel, bei dem die ersten Öffnungen einerseits und die zweiten Öffnungen andererseits an gegenüberliegenden Seiten des jeweiligen MEMS sind;
- Fig. 8a-c: schematische Seitenschnittansichten von MEMS gemäß hierin beschriebener Ausführungsbeispiele zur Erörterung einer durch die jeweiligen Öffnung erhaltenen Phasenanpassung;
- Fig. 9a: eine schematische Seitenschnittansicht eines MEMS gemäß einem Ausführungsbeispiel, das gegenüber dem MEMS aus Fig. 2 eine Phasenanpassungseinrichtung aufweist;
- Fig. 9b: eine schematische Seitenschnittansicht eines MEMS gemäß einem Ausführungsbeispiel, das gegenüber dem MEMS aus Fig. 4 durch Bereitstellen von Phasenanpassungseinrichtungen erweitert ist;
- Fig. 10: ein schematisches Flussdiagramm eines Verfahrens gemäß einem Ausführungsbeispiel, das beispielsweise zum Herstellen eines hierin beschriebenen MEMS genutzt werden kann; und
- Fig. 11: ein schematisches Flussdiagramm eines Verfahrens gemäß einem Ausführungsbeispiel, das beispielsweise zum Auslegen oder Dimensionieren eines hierin beschriebenen MEMS genutzt werden kann.

Bevor nachfolgend Ausführungsbeispiele der vorliegenden Erfindung im Detail anhand der Zeichnungen näher erläutert werden, wird darauf hingewiesen, dass identische, funktionsgleiche oder gleichwirkende Elemente, Objekte und/oder Strukturen in den unterschiedlichen Figuren mit den gleichen Bezugszeichen versehen sind, so dass die in unterschiedlichen Ausführungsbeispielen dargestellte Beschreibung dieser Elemente untereinander austauschbar ist bzw. aufeinander angewendet werden kann.

Nachfolgend beschriebene Ausführungsbeispiele werden im Zusammenhang mit einer Vielzahl von Details beschrieben. Ausführungsbeispiele können jedoch auch ohne diese detaillierten Merkmale implementiert werden. Des Weiteren werden Ausführungsbeispiele der Verständlichkeit wegen unter Verwendung von Blockschaltbildern als Ersatz einer Detaildarstellung beschrieben. Ferner können Details und/oder Merkmale einzelner Ausführungsbeispiele ohne Weiteres mit einander kombiniert werden, solange es nicht explizit gegenteilig beschrieben ist.

Nachfolgende Ausführungsbeispiele beziehen sich auf mikromechanische Bauelemente (MEMS-Bauelemente). Die hierin beschriebenen MEMS-Bauelemente können mehrschichtige Schichtstrukturen umfassen, wobei in unterschiedlichen Schichten voneinander verschiedene Funktionen ausgebildet werden können, beispielsweise eine mechanische Bewegung, das Leiten elektrischer Signale und/oder eine Krafterzeugung. Dies schließt nicht aus, in einer selben Schicht des MEMS unterschiedliche Funktionen zu kombinieren, etwa ein elektrisches Signal, eine Krafterzeugung und eine Bewegung oder auch Teile hiervon.

MEMS können beispielsweise durch Prozessieren von Halbleitermaterialien, etwa auf Wafer-Level, erhalten werden, was auch eine Kombination mehrerer Wafer und/oder die Abscheidung von Schichten auf Wafer-Ebenen beinhalten kann. Manche der hierin beschriebenen Ausführungsbeispiele gehen auf MEMS-Ebenen ein. Als eine MEMS-Ebene wird eine nicht notwendigerweise zweidimensionale oder ungekrümmte Ebene verstanden, die sich im Wesentlichen parallel zu einem prozessierten Wafer erstrecken kann, etwa parallel zu einer Hauptseite des Wafers bzw. des späteren MEMS. Eine Ebenenrichtung einer derartigen Ebene oder Schichtebene kann als eine Richtung innerhalb dieser Ebene verstanden werden, was auch mit dem englischen Begriff "in-plane" bezeichnet werden kann. Eine Richtung senkrecht hierzu, das bedeutet, senkrecht zu einer Ebenenrichtung, kann vereinfacht als Dickenrichtung oder Stapelrichtung bezeichnet werden, wobei der Begriff der Dicke keine Limitierung im Sinne einer Orientierung dieser Richtung im Raum entfaltet. Alternativ oder zusätzlich kann auch der englische Begriff "out-of-plane" verwendet werden.

Es versteht sich, dass hierin verwendete Begriffe wie "Länge", "Breite", "Höhe", "oben", "unten", "links", "rechts" und dergleichen lediglich zur Illustration hierin beschriebener Ausführungsbeispiele herangezogen werden, die die Erfindung aber nicht beschränken, da die jeweilige Lage eines Elements im Raum beliebig veränderbar ist und die Ausführungsbeispiele insofern auch in anderen Orientierungen positioniert werden können.

Manche der hierin beschriebenen Ausführungsbeispiele werden im Zusammenhang mit der Erzeugung periodischer Oszillationen in einem Fluid, etwa Schallwellen, Ultraschallwellen, akustische Wellen oder dergleichen, beschrieben. Derartige Ausgestaltungen schließen jedoch eine komplementäre Implementierung als Sensor zur sensorischen Auswertung mithilfe des MEMS-Bauelements aber nicht aus, etwa analog zu einer Mikrofon-Funktion des MEMS oder dergleichen. Ausführungsbeispiele beziehen sich darauf, eine Bewegung eines beweglichen Elements in einer Kavität durch unterschiedliche Phasenverzögerungen in Öffnungen zwischen der Kavität und der Umgebung gut nutzbar zu machen. Es versteht sich, dass eine derartige Phasenverschiebung auch bei einer sensorischen Auswertung gut nutzbar ist.

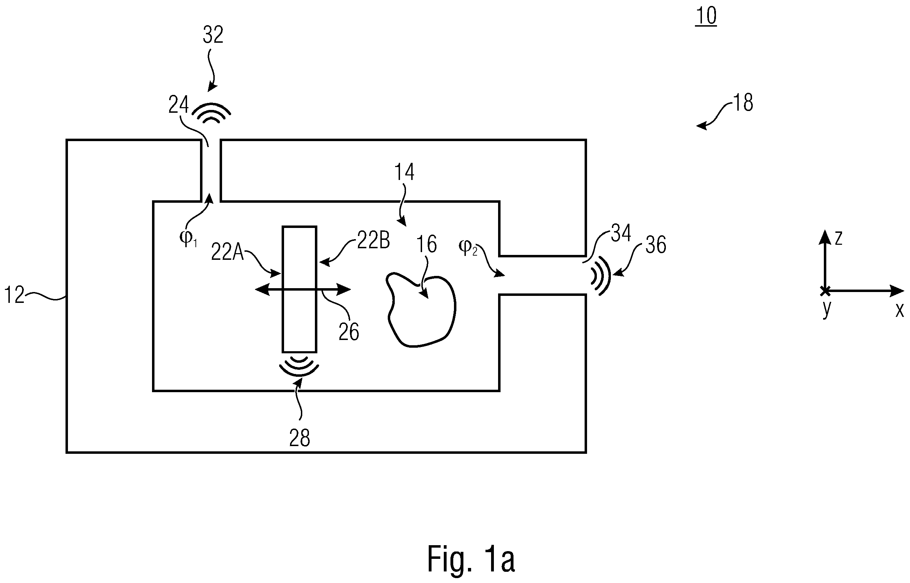

Fig. 1a zeigt eine schematische Seitenschnittansicht eines MEMS 10 gemäß einem Ausführungsbeispiel. Das MEMS umfasst ein Substrat 12 und eine in dem Substrat 12 angeordnete Kavität 14. In der Kavität 14 kann ein Fluid 16 angeordnet sein, das beispielsweise eine Zusammensetzung in Übereinstimmung mit einer Umgebung 18 des MEMS aufweisen kann, beispielsweise Luft oder eine andere Zusammensetzung gemäß der Umgebung 18.

Das Substrat kann einschichtig oder mehrschichtig gebildet sein und beispielsweise ein Halbleitermaterial umfassen, beispielsweise Silizium oder ein siliziumbasiertes Material, andere Halbleitermaterialien oder eine Kombination hiervon. Alternativ oder zusätzlich kann das Substrat 12 prinzipiell auch anders gebildet sein, wobei zumindest ein Teilbereich oder eine Schicht möglicherweise elektrisch leitfähige Materialien umfassen kann, beispielsweise um elektrische Leistung oder Informationssignale zu leiten.

Das MEMS 10 umfasst ein in der Kavität 14 angeordnetes bewegliches Element 22. Das bewegliche Element 22 ist ausgebildet, um mit dem Fluid 16 zu interagieren. Eine Bewegung des Fluids 16 und eine Bewegung des beweglichen Elements 22 hängen dabei kausal miteinander zusammen. Das bedeutet, dass eine möglicherweise elektrisch oder thermisch angetriebene Bewegung des beweglichen Elements 22 zu einer Bewegung des Fluids 16 führen kann und/oder dass eine Bewegung des Fluids 16, beispielsweise aufgrund eines Druckunterschiedes oder einer Druckvariation in der Umgebung 18, eine Bewegung des beweglichen Elements 22 verursachen kann.

Das MEMS umfasst eine erste Öffnung 24 in dem Substrat, welche die Kavität mit der Umgebung 18 des Substrats 12 verbindet. Beim Durchqueren der ersten Öffnung 24 kann eine in dem Fluid 16 erzeugte Druckwelle, Schwingung oder periodische Oszillation eine Phasenverschiebung oder einen Phasenversatz erfahren. Die periodische Oszillation kann als Welle oder Schallwelle bezeichnet werden. Ein Frequenzbereich kann im hörbaren Bereich liegen, kann aber auch außerhalb hiervon angeordnet sein, beispielsweise in einem Ultraschall- oder Infraschallbereich. Insofern ist die Bezeichnung akustische Welle im Zusammenhang mit hierin beschriebenen Ausführungsbeispielen nicht einschränkend, sondern lediglich exemplarisch bezüglich des Frequenzbereichs.

Beispielsweise kann basierend auf einer Bewegung des beweglichen Elements 22 entlang einer Bewegungsrichtung 26, die beispielsweise in-plane entlang positiver und negativer x-Richtung angeordnet sein kann, eine periodische Oszillation 28 in der Kavität 14 erzeugt werden. Diese kann beim Durchqueren der Öffnung 24 einen Phasenversatz erfahren und als phasenversetzte Oszillation 32 in die Umgebung 18 emittiert werden.

Das MEMS 10 umfasst eine zweite Öffnung 34 in dem Substrat 12, welche die Kavität 14 ebenfalls mit der Umgebung 18 des Substrats 12 verbindet. Auch die Öffnung 34 stellt einen Phasenversatz für die periodische Oszillation 28 bereit, so dass eine zweite phasenversetzte Oszillation 36 aus der Öffnung 34 von dem MEMS 10 in die Umgebung 18 emittiert werden kann. Der von der Öffnung 24 bewirkte Phasenversatz ist dabei von dem durch die Öffnung 34 bewirkten Phasenversatz verschieden.

Die periodische Oszillation 28, die von dem beweglichen Element 22 bereitgestellt wird, ist dabei lediglich exemplarisch als eine gemeinsame periodische Oszillation dargestellt. Dies ist basierend auf einer Anordnung oder Positionierung der jeweiligen Öffnungen 24 und 34 auch problemlos möglich. Alternativ kann das bewegliche Element 22 die Kavität 14 auch in zumindest zwei Teilkavitäten unterteilen und jeweils eine in der Teilkavität erzeugte periodische Oszillation kann eine Grundlage für die jeweils phasenversetzte Oszillation 32 bzw. 36 bilden. Dadurch kann beispielsweise eine Ausgestaltung erhalten werden, dass das bewegliche Element eine erste Seite 22A und eine gegenüberliegende zweite Seite 22B aufweisen kann. Das bewegliche Element 22 kann ausgebildet sein, um bei einer mit der Bewegung des beweglichen Elements 22 assoziierten Verdrängung des Fluids 16 mit der ersten Seite 22A die periodische Oszillation 32 zu erzeugen und das Fluid durch die Öffnung 24 zu bewegen. Bei einer Bewegung des mit dem beweglichen Elements 22 und einer damit assoziierten Verdrängung des Fluids 16 mit der Seite 22B kann die periodische Oszillation 36 erzeugt werden und das Fluid durch die Öffnung 34 bewegt werden. Die unterschiedlichen Seiten 22A und 22B können als phasen-verschiedene Seiten des abstrahlenden beweglichen Elements 22 verstanden werden

Gemäß einem Ausführungsbeispiel kann eine Schallführung mit der Seite 22A durch die Öffnung 24 von einer Schallführung mit der Seite 22B durch die Öffnung 34 basierend auf den voneinander verschiedenen Phasenversätzen voneinander verschieden sein.

Gemäß anderen Ausführungen ist es aber ohne Probleme möglich, die Öffnungen 24 und 34 unter Anwendung unterschiedlicher Phasenverzögerungen auch mit einer durch dieselbe Seite 22A oder 22B verursachten oder erzeugten Oszillation zu beaufschlagen.

Das bewegliche Element 22 kann eine aktive Struktur oder eine passive Struktur umfassen. So kann das bewegliche Element 22 beispielsweise eine Plattenstruktur oder eine Balkenstruktur oder dergleichen umfassen, die starr oder elastisch gebildet sein kann und die mit einer Aktuatoreinrichtung gekoppelt sein kann, um die Struktur zu bewegen. Hierfür können sich beispielsweise elektrostatische, elektrodynamische, piezoelektrische oder thermische Aktuatoren eignen.

Ohne weiteres ist es aber auch möglich, das bewegliche Element 22 selbst als aktive Struktur zu bilden. So können beispielsweise zwei oder mehrere im Wesentlichen parallel zueinander verlaufende Balkenstrukturen angeordnet werden, die an diskreten Bereichen miteinander fest verbunden sind. Beispielsweise in einer Ausgestaltung als Elektrodenstrukturen kann durch Anlegen eines elektrischen Potenzials die Bewegung des beweglichen Elements 22 erhalten werden, etwa durch Verformung des beweglichen Elements 22.

Der Phasenversatz der Öffnung 24 und der Phasenversatz der Öffnung 34 können beispielsweise basierend auf einem thermoviskosen Effekt bereitgestellt werden, etwa indem das Fluid 16 durch den verengten Bereich gedrückt wird und dadurch der thermoviskose Effekt ausgelöst wird. Zur Erzeugung unterschiedlicher Ausmaße des Phasenversatzes können sich die Öffnungen 24 und 34 dabei in zumindest einem aus einem Öffnungsquerschnitt der Öffnung, einem Verlauf des Öffnungsquerschnitts entlang einer Richtung durch das Substrat und einer Tiefe in dem Substrat voneinander unterscheiden.

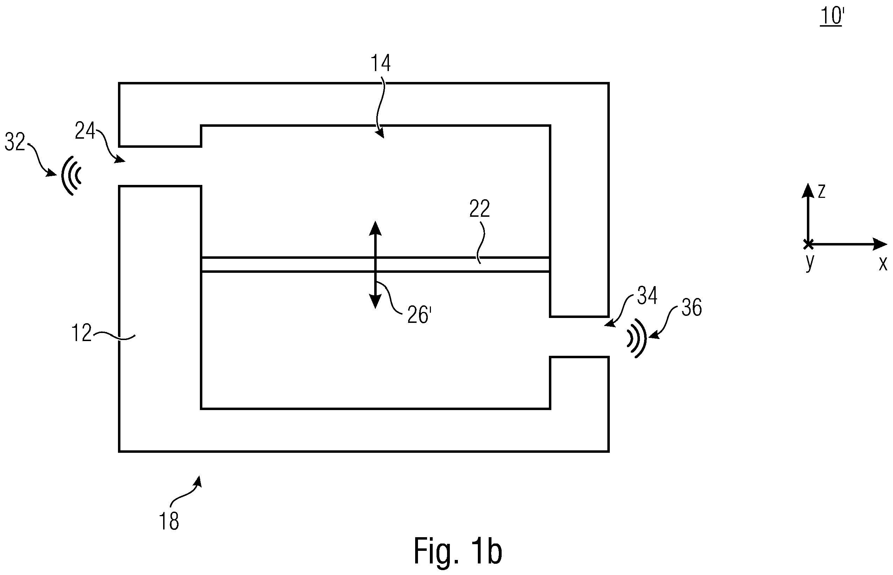

Fig. 1b zeigt eine schematische Seitenschnittansicht eines MEMS 10' gemäß einem Ausführungsbeispiel. Verglichen mit dem MEMS 10 ist das bewegliche Element 22 beispielsweise als entlang der Ebenenrichtungen x/y aufgehängte Membranstruktur gebildet, wobei auch eine andere Ausgestaltung umsetzbar ist, die eine Auslenkung entlang einer Auslenkungsrichtung 26', beispielsweise parallel zur z-Richtung, ermöglicht, die gemäß einem Ausführungsbeispiel out-of-plane ist.

Das MEMS 10' kann ebenso wie das MEMS 10 basierend auf der Bewegung des beweglichen Elements 22 phasenversetzte periodische Oszillationen 32 und 36 bereitstellen, die beispielsweise aufgrund unterschiedlicher Phasenversatzbeiträge durch die Öffnungen 24 und 34 erhalten werden.

Im Ausführungsbeispiel der Fig. 1b sind die Öffnungen 24 und 34 an phasen-verschiedenen Seiten des beweglichen Elements 22 angeordnet, wobei die Öffnungen 24 und 34 auch auf derselben Seite angeordnet sein können.

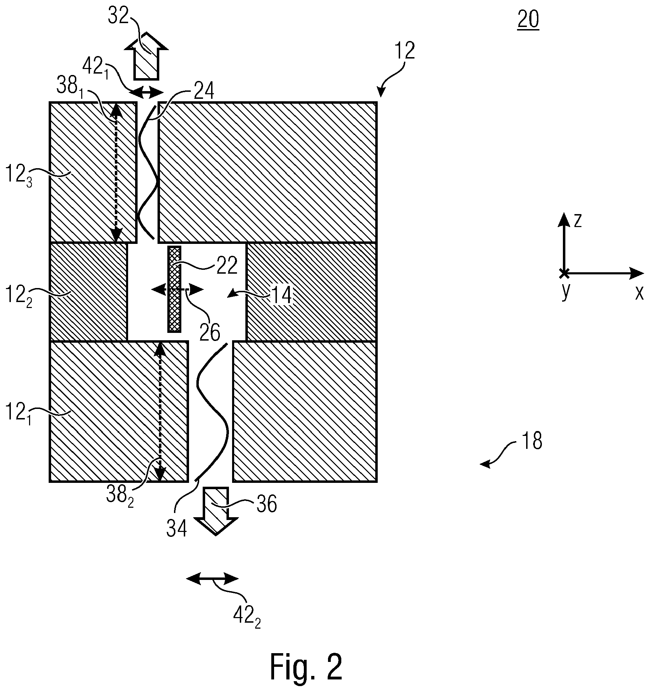

Fig. 2 zeigt eine schematische Seitenschnittansicht eines MEMS 20 gemäß einem Ausführungsbeispiel. Das Substrat ist dabei beispielhaft mehrschichtig gebildet und umfasst zumindest zwei, in der konkreten Darstellung drei, Schichten 12₁, 12₂ und 12₃. Die Schicht 12, kann beispielsweise als Bodenwafer bezeichnet werden oder daraus gebildet sein, während die Schicht 12₂ umfassend das bewegliche Element 22 als Devicewafer bezeichnet werden kann. Die Schicht 12₃ kann zusammen mit der Schicht 12, die Kavität 14 entlang der z-Richtung begrenzen, so dass die Schicht 12₃ auch als Deckelwafer bezeichnet werden kann. Die Öffnungen 24 und 34 sind beispielhaft in den Schichten 12₃ bzw. 12, angeordnet.

Die voneinander verschiedenen Beiträge zum Phasenversatz können beispielsweise basierend auf unterschiedlichen Dicken 38₁ und 38₂ in den Schichten 12₃ bzw. 12, erhalten werden. Dies kann beispielsweise einfach dadurch erhalten werden, indem die entsprechenden Schichten 12₁ und 12₃ in unterschiedlichen Dicken bereitgestellt werden. Alternativ oder zusätzlich ist es aber auch ebenfalls möglich, die Öffnung 24 und/oder 34 in einem Bereich der Kavität 14 bzw. der Umgebung 18 lokal so stark zu vergrößern, dass in dem vergrößerten Bereich effektiv kein Beitrag zur Phasenverzögerung erfolgt oder ein vernachlässigbarer Beitrag. Alternativ oder zusätzlich zu unterschiedlichen Abmessungen 38, und 38₂ entlang der z-Richtung kann eine Abmessung 42₁ bzw. 42₂ entlang der x-Richtung und/oder y-Richtung voneinander verschieden sein, also beispielsweise eine unterschiedliche Länge oder eine unterschiedliche Breite oder eine voneinander verschiedene Querschnittsfläche implementiert werden. Durch den Phasenversatz zwischen den Öffnungen oder Luftauslässen 24 und 34, etwa basierend auf unterschiedlicher Geometrie der Luftauslässe, kann eine Steuerung der Richtcharakteristik einer Überlagerung der periodischen Oszillationen 32 und 36 erhalten werden.

In anderen Worten zeigt Fig. 2 den Querschnitt durch einen Waferstapel aus drei Schichten mit einem Verdrängerelement oder beweglichen Element. Das Verdrängerelement hat eine erste und eine zweite Verdrängerseite und je zwei unterschiedlich geformte Luftauslassöffnungen, die an vorzugsweise unterschiedlichen, aber grundsätzlich beliebigen Chipseiten enden. Durch die Wahl der Position, der geometrischen Form und der Breite wird zwischen den austretenden Wellen ein Phasenversatz erzeugt, welcher zum Formen einer Richtcharakteristik im Freifeld genutzt werden kann. Die Tiefe der Luftöffnungen entlang der z-Richtung kann beispielsweise im Bereich von zumindest 1 µm bis 1500 µm, bevorzugt von zumindest 200 µm und höchstens 800 µm liegen. Die dargestellte Breite 42₁ und/oder 42₂ der Öffnungen 24 bzw. 34 kann beispielhaft einen Wert von zumindest 1 µm bis höchstens 150 µm und bevorzugt von zumindest 10 µm bis höchstens 50 µm betragen, wobei das derartige Konzept auf beliebige andere Abmessungen übertragbar ist.

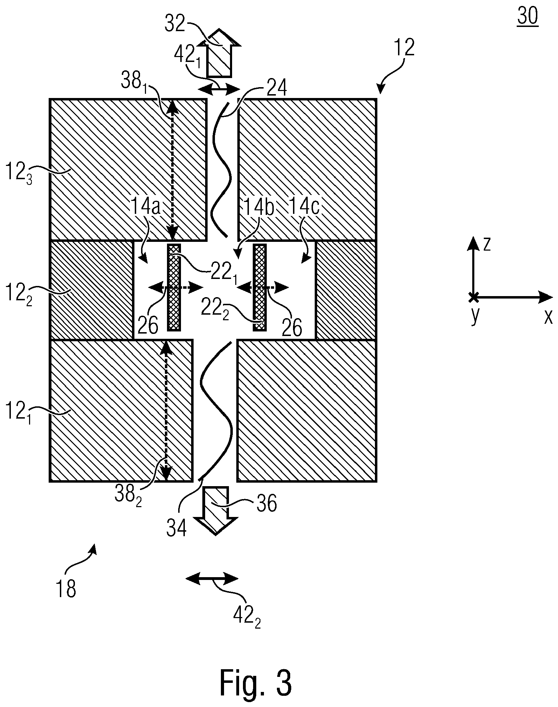

Fig. 3 zeigt ein schematisches Blockschaltbild eines MEMS 30 gemäß einem Ausführungsbeispiel. Die Kavität 14 wird durch zwei bewegliche Elemente 22₁ und 22₂ in insgesamt drei Teilkavitäten 14a, 14b und 14c unterteilt, wobei die Anzahl von drei Teilkavitäten und die Anzahl von zwei beweglichen Elementen lediglich beispielhaft ist. Durch antiphasische Anregung der beweglichen Elemente 22₁ und 22₂, so dass diese sich entlang der x-Richtung aufeinander zu und voneinander weg bewegen, kann eine Druckvariation in den periodischen Oszillationen 32 und 34 gegenüber dem MEMS 20 erhöht werden. Gleichzeitig ermöglicht das MEMS 30, ggf. unter Vornahme zusätzlichen Anpassungen, zusätzliche Freiheitsgrade. So kann beispielweise alternativ oder zusätzlich zum Verbinden der Teilkavität 14b mit der Umgebung 18 auch die Teilkavität 14a und/oder 14c mit der Umgebung 18 verbunden werden. Werden die beweglichen Elemente 22₁ und 22₂ beispielsweise mit voneinander verschiedenen Frequenzen und/oder phasenversetzt zueinander angesteuert, kann ein Spektrum einer Überlagerung der periodischen Oszillationen 32 und 36 angepasst werden.

Wie auch beim MEMS 10 und/oder dem MEMS 20 kann eine Ausgestaltung dergestalt erfolgen, dass die Öffnungen 24 und 34 ausgebildet sind, um die jeweilige periodische Oszillation 32 bzw. 36 in ein gemeinsames Volumen, die Umgebung 18, abzugeben, in welchem sich die periodische Oszillationen 32 und 36 überlagern. In einem Fernfeld des MEMS 30 findet dabei bevorzugt keine gegenseitige Auslöschung der erhaltenen periodischen Oszillationen statt, das bedeutet, eine Überlagerung der periodischen Oszillationen 32 und 36 ist frei von einem akustischen Kurzschluss.

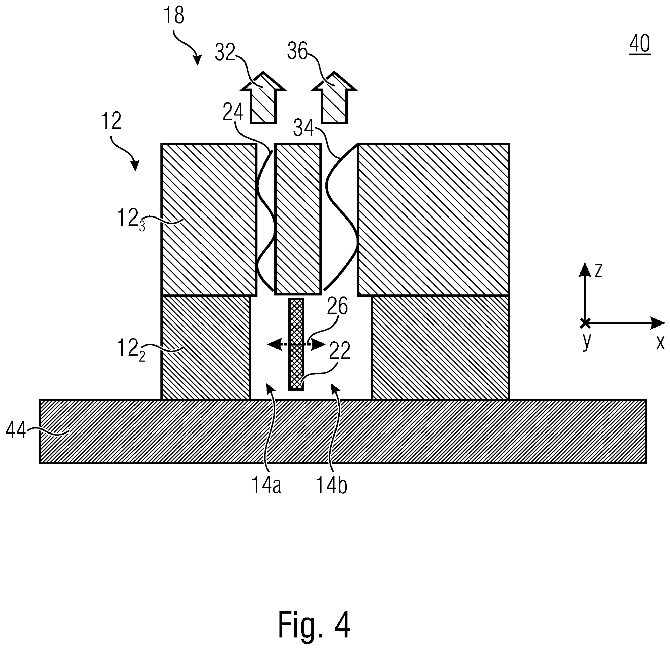

Fig. 4 zeigt eine schematische Seitenschnittansicht eines MEMS 40 gemäß einem Ausführungsbeispiel. In der Ausführungsform des MEMS 40 sind die Öffnungen 24 und 34 an einer gleichen Seite des Substrats 12 angeordnet. So kann beispielsweise die Schicht 12₃ die Öffnungen 24 und 34 nebeneinander angeordnet aufweisen. Gemäß einer möglichen Ausführungsform können dabei die unterschiedlichen Phasenverschiebungen so ausgelegt werden, dass die periodischen Oszillationen 32 und 36 gleichphasig oder innerhalb eines Toleranzbereichs gleichphasig zueinander austreten. Eine Abweichung von einer Gleichphasigkeit ermöglicht beispielsweise das Einstellen einer Richtcharakteristik in einer Richtung, die gegenüber der z-Achse geneigt ist.

Eine Anregung der periodischen Oszillationen 32 und 36 kann beispielsweise aufgrund der Ausgestaltung des beweglichen Elements 22 in zwei um 180° phasenversetzt zueinander angeordneten periodischen Oszillationen in den Teilkavitäten 14a und 14b liegen. Bei einer Auslegung der Öffnungen 24 und 34 dergestalt, dass eine erneute 180°-Phasendrehung zueinander erfolgt, können die beiden periodischen Oszillationen 32 und 34 wieder gleichphasig zueinander sein.

Wie auch bei dem MEMS 10, 10', 20 und/oder 30 kann auch beim MEMS 40 eine voneinander verschiedene Korrelation der Bewegung des beweglichen Elements 22 zu dem jeweiligen durch die Öffnung 24 bzw. 34 bereitgestellten Phasenversatz vorliegen. Der durch die Öffnung 24 bereitgestellte Phasenversatz und der durch die Öffnung 34 bereitgestellte Phasenversatz können eine Beziehung zueinander aufweisen, die dergestalt ausgelegt werden kann, dass die Phasenbeziehung zwischen den periodischen Oszillationen 32 und 36 eine vorbestimmte Eigenschaft aufweist. Gemäß einer Ausführungsform kann dies so eingestellt werden, dass innerhalb eines Toleranzbereichs eine übereinstimmende Phase der periodischen Oszillationen 32 und 36 vorliegt, wenn diese in die Umgebung 18 abgegeben werden. Alternativ kann basierend auf einer Abweichung von einer übereinstimmenden Phase und deshalb basierend auf der Beziehung zwischen dem ersten Phasenversatz und dem zweiten Phasenversatz der Öffnung 24 bzw. der Öffnung 26 bei einer Überlagerung der periodischen Oszillationen 32 und 36 eine Richtcharakteristik erhalten werden, mit der die Überlagerung der periodischen Oszillationen 32 und 36 in die Umgebung abgegeben wird.

Verglichen mit den MEMS 20 und 30 kann eine Schicht des Substrats 12 beispielsweise als Platine 44 gebildet sein, um die Kavität bzw. die Teilkavitäten 14a und/oder 14b entlang der negativen z-Richtung zu begrenzen. Alternativ kann ohne weiteres ein Handlingwafer angeordnet sein.

In anderen Worten zeigt Fig. 4 einen Waferstapel aus zwei Schichten und mit einem Verdrängerelement. Das Verdrängerelement hat eine erste und eine zweite Verdrängerseite und je zwei unterschiedlich geformte Luftauslassöffnungen, die vorzugsweise an der gleichen Chipseite enden. Die Tiefen und Breiten können vergleichbar zum MEMS 20 sein. Durch die Wahl der Position, der geometrischen Form und der Breite kann zwischen den austretenden Wellen ein Phasenversatz erzeugt werden, welcher den akustischen Kurzschluss an der Chipoberfläche verhindert, wodurch ein möglichst großer Teil der Energie für die Erzeugung von Schallwellen, akustischen Wellen bzw. des synonym verwendeten Begriffs periodischer Oszillation des Chips verwendet werden kann. Dies erlaubt die Vermeidung eines Rückvolumens.

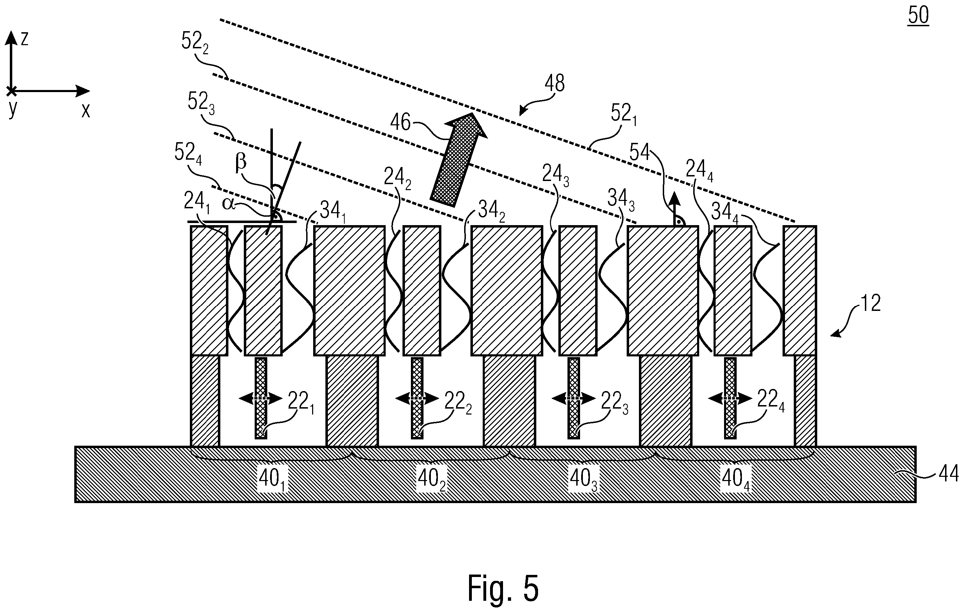

Fig. 5 zeigt eine schematische Seitenschnittansicht eines Arrays 50 gemäß einem Ausführungsbeispiel. Das Array 50 umfasst beispielhaft zumindest zwei MEMS, beispielhaft vier 40₁-40₄, wobei ohne weiteres alternativ oder zusätzlich auch andere MEMS 10, 10', 20 und/oder 30 angeordnet werden können. Ein Array in Übereinstimmung mit hierin beschriebenen Ausführungsbeispielen kann zumindest zwei, zumindest drei, zumindest vier oder eine höhere Anzahl von zumindest fünf, zumindest sieben, zumindest zehn oder mehr gleichartiger oder verschiedenartiger MEMS umfassen. Beispielhaft aber nicht notwendigerweise sind hier die jeweiligen MEMS so ausgebildet, dass die Phasenbeziehung zwischen den Öffnungen 24 und 34 eingerichtet ist, um eine geneigte Abstrahlrichtung 46 zu erhalten, die gegenüber einer Oberflächennormalen, beispielsweise parallel zur z-Richtung des Substrats, um einen Winkel β und/oder zur Oberfläche des Substrats 12 um einen Winkel *α, β* ≠ *n ·* 90° *mit n* = 1, 2, 3, 4 geneigt ist.

Ein örtlicher Versatz der unterschiedlichen MEMS 40₁-40₄ entlang der x-Richtung kann durch eine phasenversetzte Anregung der beweglichen Elemente 22₁-22₄ berücksichtigt werden, um die gemeinsame erhaltene Wellenfront 48, welche durch eine Wellenfront bzw. mehrere Linien 52₁-52₄ gleicher Phase charakterisiert werden kann, zu erhalten. Alternativ oder zusätzlich kann eine derartige Phasenbeziehung auch durch eine voneinander verschiedene Ausgestaltung der jeweiligen Öffnungen 24₁-24₄ zueinander sowie 34₁-34₄ zueinander erhalten werden.

Das Array 50 kann mit beiden Varianten, aber auch kombinatorisch ausgebildet sein, um die phasenversetzten Oszillationen 32 und die phasenversetzten Oszillationen 36 der MEMS 40₁-40₄ mit einer gemeinsamen Richtcharakteristik auszusenden. Hierzu können die Richtcharakteristiken 32 aufeinander abgestimmt sein und/oder die Richtcharakteristiken 34 aufeinander abgestimmt sein.

In anderen Worten zeigt Fig. 5 eine Erweiterung der Anordnung der Fig. 4, wo die einseitigen Luftauslassöffnungen die zusätzliche Funktion eines Arrays übernehmen. Der Phasenversatz ist hier so gewählt, dass die entstehende Wellenfront nicht parallel zu der Chipoberfläche ist. Somit wird der Wandler eine ausgeprägte Hauptkeule zeigen, welche nicht senkrecht zur Chipfläche ausgerichtet ist. Der Winkel ist hier durch die Bragg-Bedingung beschränkt und kann somit durch die Periodizität der Verdrängerelemente 22₁-22₄ und die Freifeld-Wellenlänge zumindest teilweise bestimmt werden.

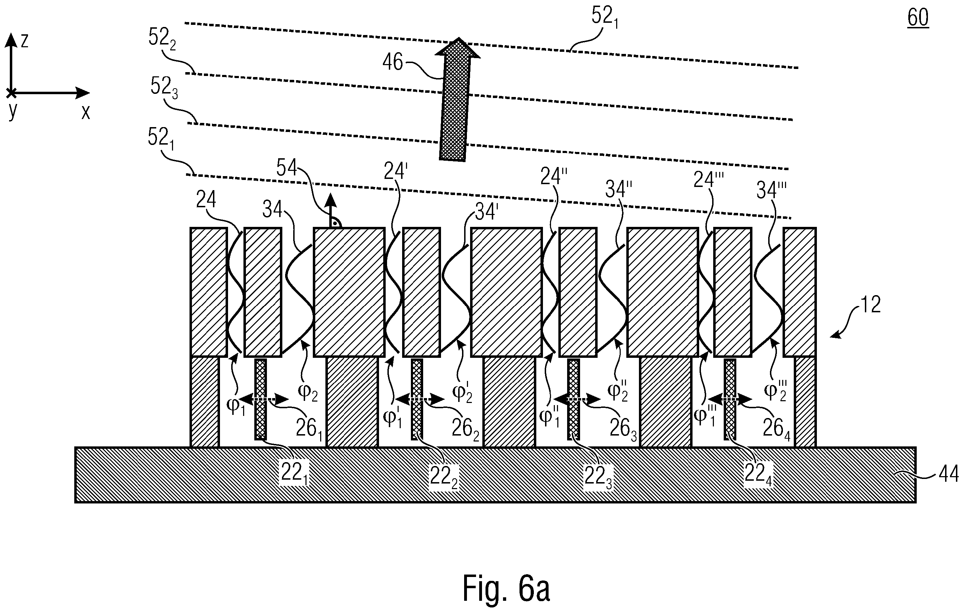

Fig. 6a zeigt eine schematische Seitenschnittansicht eines Arrays 60 gemäß einem Ausführungsbeispiel, bei dem die angeordneten MEMS voneinander verschieden gebildet sind, so dass sich ein Phasenversatz ϕ₁, ϕ_{1'}, ϕ_{1"} und ϕ_{1‴} unterschiedlicher MEMS voneinander unterscheidet. Ein derartiges Array kann auch als MEMS-Array bezeichnet werden. Alternativ oder zusätzlich zu einem voneinander verschiedenen Phasenversatz können sich ein Phasenversatz ϕ₂, ϕ_{2'}, ϕ_{2"} und ϕ_{2‴} voneinander unterscheiden, um die gegenüber der Oberflächennormalen 54 geneigte Abstrahlrichtung 46 zu erhalten. Dabei kann eine Phasendifferenz ϕ₂ - ϕ₁ bzw. ϕ_{2'} - ϕ_{1'} und/oder ϕ_{2"} - ϕ_{1"} und/oder ϕ_{2‴} - ϕ_{1‴} der unterschiedlichen MEMS zumindest annähernd identisch sein.

Gemäß einem in Fig. 6a gezeigten Ausführungsbeispiel ist das Array ausgebildet, um die phasenversetzten periodischen Oszillationen 32 der MEMS 40₁-40₄ mit einer gemeinsamen Richtcharakteristik auszusenden, die bezogen auf eine Oberflächennormale 54 des Substrats 12 und eine Richtung der Öffnungen 24, hier beispielhaft die z-Richtung, schräg angeordnet ist und bei dem die Öffnungen 24₁-24₄ für einen voneinander verschiedenen Phasenversatz eingerichtet sind. Alternativ oder zusätzlich kann ein hierin beschriebenes Array, etwa das Array 50, ausgebildet sein, um die phasenversetzten periodischen Oszillationen 36, die die Öffnungen 34₁-34₄ durchlaufen, mit einer gemeinsamen Richtcharakteristik auszusenden, die bezogen auf die Oberflächennormale 54 und einer Richtung der Öffnungen 34₁-34₄, beispielhaft die z-Richtung, schräg angeordnet ist. Hier können die Öffnungen 34₁-34₄ für einen voneinander verschiedenen Phasenversatz eingerichtet sein.

In anderen Worten zeigt Fig. 6a eine Erweiterung der Anordnung aus Fig. 5, wo die Luftaustrittsöffnungen in weitere Gruppen, gemäß dem MEMS 40₁, dem MEMS 40₂, dem MEMS 40₃ und dem MEMS 40₄, aufgeteilt werden, welche sich zusätzlich untereinander in ihren geometrischen Abmessungen und/oder der Form unterscheiden. Dadurch kann ein zusätzlicher Phasenversatz des Wellenaustritts zwischen den einzelnen Verdrängern realisiert werden. Dieser Aufbau erlaubt es, die Grenzen der Bragg-Bedingung zu überwinden und Hauptkeulen zu designen, deren Winkel unabhängig von der Periodizität der Verdrängerelemente ist.

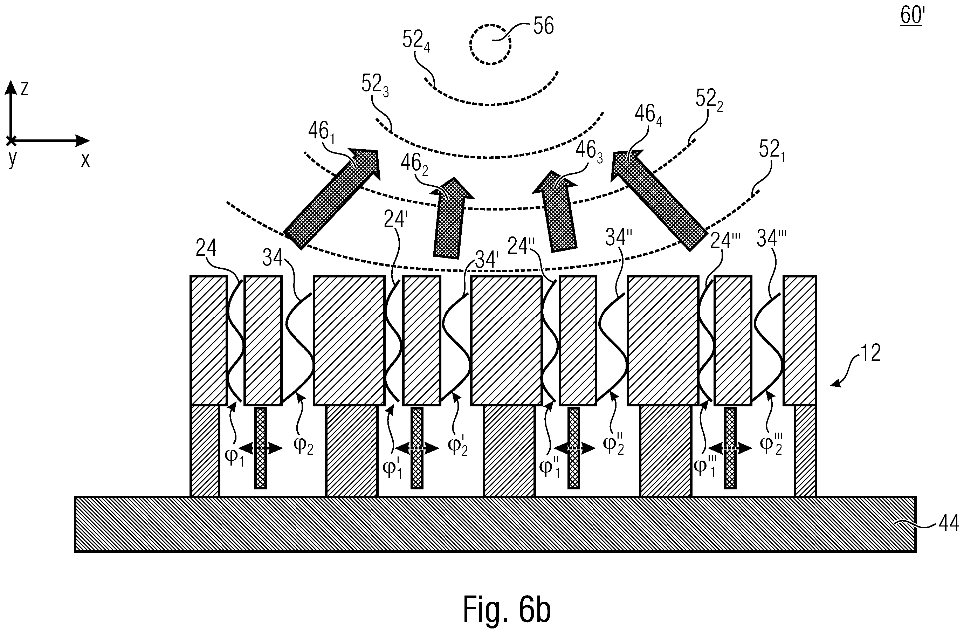

Fig. 6b zeigt eine schematische Seitenschnittansicht eines Arrays 60', für welches die Ausführung zum MEMS 60 in weiten Teilen gelten. Abweichend vom Array 60 kann das Array 60' so ausgeführt sein, dass unter Auslegung der jeweiligen Phasenverschiebungen ϕ₁-ϕ_{2‴} voneinander abweichende Ausbreitungsrichtungen 46₁-46₄ der MEMS-Bereiche erhalten werden können. Eine Überlagerung der jeweiligen periodischen Oszillationen kann anders als beim Array 60 zu zumindest näherungsweise gekrümmten Wellenfronten 52₁-52₄ führen. Das Array 60' kann ausgebildet sein, um die emittierten periodischen Oszillationen auf einen gemeinsamen Fokusbereich 56 zu richten bzw. zu fokussieren. Alternativ hierzu können jeweils Gruppen von MEMS-Komponenten oder MEMS-Bereichen oder Einzel-MEMS genutzt werden, um einen jeweiligen Fokusbereich 56 anzufokussieren, so dass insgesamt mehrere räumlich disjunkte oder miteinander überlappende Fokusbereiche mit den periodischen Oszillationen beaufschlagt werden können.

Das bedeutet, dass die Mehrzahl an Öffnungen 24, die einen jeweiligen Phasenversatz der sie durchlaufenden periodischen Oszillationen bereitstellen können, die austretenden Wellen oder periodischen Oszillationen auf einen gemeinsamen Fokusbereich 56 richten können, zumindest gruppenweise. Alternativ oder zusätzlich können die Öffnungen 34, 34', 34" und 34‴ basierend auf einer Überlagerung phasenversetzter periodischer Oszillationen diese auf einen ebenfalls gemeinsamen Fokusbereich richten. So könnten beispielsweise durch Abstimmung der Öffnungen 24-24‴ ein erster Fokusbereich erzeugt und durch Abstimmung der Öffnungen 34-34‴ ein zweiter Fokusbereich erzeugt werden. Diese Fokusbereiche können einander überlagern, aneinander angrenzen, um eine Vergrößerung des Gesamtfokusbereichs zu bewirken oder können räumlich disjunkt voneinander sein.

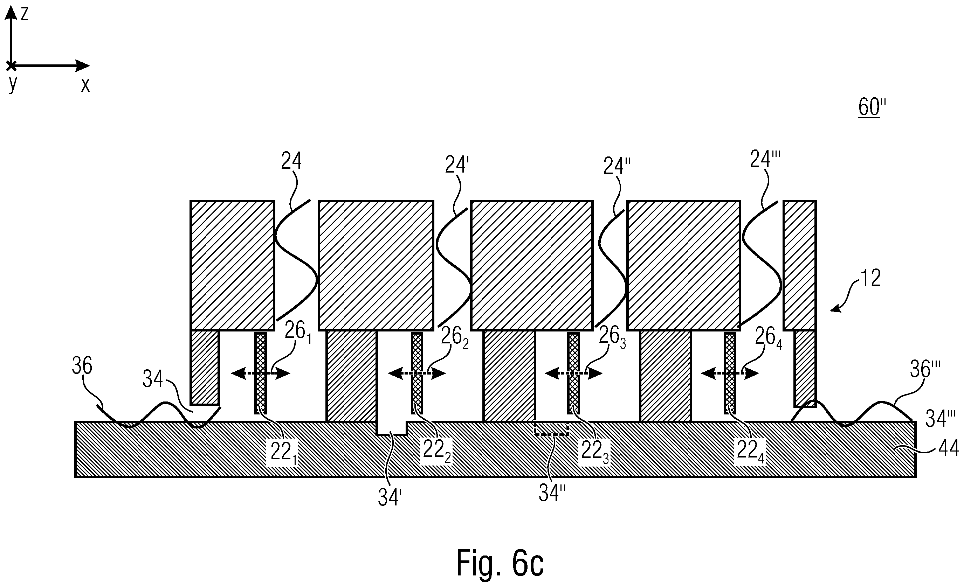

Fig. 6c zeigt eine schematische Seitenschnittansicht eines Arrays 60" gemäß einem Ausführungsbeispiel. Dort sind die jeweiligen zweiten Öffnungen 34, 34', 34" und 34‴ zu unterschiedlichen Raumrichtungen -x, -y, +y, +x ausgerichtet. Eine derartige Nutzung zweier oder mehrerer Raumrichtungen für die ersten Öffnungen 24-24‴ einerseits als auch 34-34‴ andererseits kann für eine der Öffnungen 24/34 oder beide erfolgen und kann gleich zueinander oder voneinander verschieden ausgebildet sein. Es sei darauf hingewiesen, dass die beweglichen Elemente 22₁-22₄ synchron zueinander als auch voneinander verschieden angesteuert werden können.

Die Verwendung eines gemeinsamen Trägersubstrats bzw. einer Platine 44 für die Einhausung der Kavitäten kann es ermöglichen, eine oder mehrere der Öffnungen 34, 34', 34" oder 34‴ durch einfache Ausgestaltung der Platine 44 zu erzeugen, beispielsweise durch Einbringen von Furchen, Gräben und/oder Löchern. Sämtliche der Öffnungen 34-34‴ können hierbei entsprechend ausgebildet sein, es kann aber auch, wie dargestellt, eine Kombination durch Einfügen von Öffnungen im Halbleitermaterial des Substrats 12 einerseits, siehe Öffnungen 34 und 34‴, zusammen mit der Bearbeitung der Platine 44 erfolgen, wie es für die Öffnungen 34' und 34" dargestellt ist. Das bedeutet, Ausführungsbeispiele ermöglichen auch eine Einstellung eines Phasenversatzes über die Aufbau- und Verbindungstechnik (AVT) ggf. unter Verwendung einer speziellen Trägerplatine mit entsprechenden Gräben, Furchen, Löchern und/oder des verwendeten Klebers. Hierzu kann die Trägerplatine spezielle Anpassungen aufweisen, wie die erwähnten Gräben, Furchen und/oder Löcher, eine Anpassung kann dabei jeweils pro Verdrängerkammer bzw. entsprechender Kavität erfolgen. Ein verwendeter Kleber zur Verbindung zwischen Chip und Trägerplatine kann ferner oder als Alternative hierzu zur Kanalgestaltung eingesetzt werden, etwa als Füllmaterial oder zur Einstellung einer Kanalhöhe.

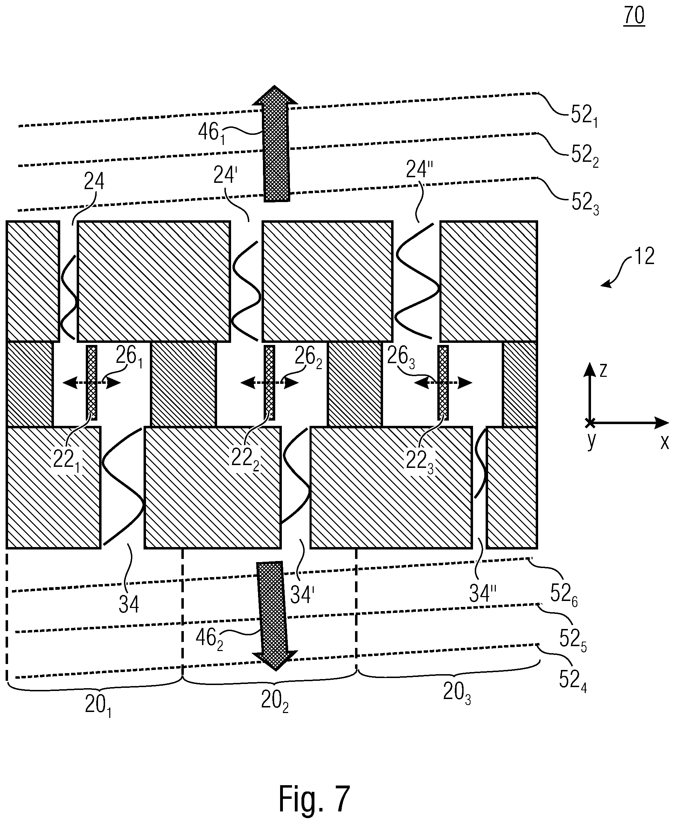

Fig. 7 zeigt eine schematische Seitenschnittansicht eines Arrays 70 gemäß einem Ausführungsbeispiel. Verglichen mit dem Array 60 sind die Öffnungen 24, 24' und 24" einerseits und 34, 34' und 34" andererseits an gegenüberliegenden Seiten des jeweiligen MEMS 20₁, 20₂ und 20₃ angeordnet. Wie auch in anderen hierin beschriebenen Arrays können die einzelnen MEMS-Strukturen 20₁, 20₂ und 20s eine von drei verschiedene Anzahl aufweisen und gleich zueinander bzw. voneinander abweichend gebildet sein. Es versteht sich dabei, dass die jeweiligen MEMS eines Arrays einzelne MEMS-Bausteine bilden können, aber auch monolithisch miteinander einstückig gebildet sein können.

Auch wenn die beiden Austrittsseiten der Wellenfronten 52₁-52₃ einerseits als auch 52₄-52₆ andererseits als gegenüberliegend zueinander dargestellt sind, können auch beliebige andere voneinander verschiedene Seiten gewählt werden oder, wie im Zusammenhang mit der Fig. 5 oder der Fig. 6a erläutert, dieselbe Seite.

Die Verwendung unterschiedlicher Seiten ermöglicht es, die jeweiligen Vorteile an mehr als einer Seite zu nutzen, so dass Ausbreitungsrichtungen 46₁ und 46₂ unabhängig voneinander eingestellt und ausgelegt werden können.

In anderen Worten zeigt Fig. 7 eine Kombination der Ausführungen der Fig. 2 und Fig. 6a, wo die Luftaustrittsöffnungen sich auf unterschiedlichen Chipseiten befinden und sich in ihrer Geometrie und ggf. Position unterscheiden. Dabei werden beide Chipseiten als eine Array-Konfiguration ausgeführt, wobei die Winkel der beiden Hauptkeulen unabhängig voneinander designt werden können.

Während die Arrays 60 und 60' eine bezogen auf die Oberflächennormale des Substrats und/oder die Richtung der jeweiligen Öffnungen 24/34 schräge Ausbreitungsrichtung 46 zeigen, kann eine derartige schräge Ausgestaltung an beiden Seiten des Chips durch entsprechende Öffnungen erhalten werden, wie es beispielweise für das Array 70 gezeigt ist. Eine derartig schräge Ausgestaltung ist aber nicht auf Arrays von hierin beschriebenen MEMS beschränkt, sondern kann auch bereits durch ein einzelnes MEMS erreicht werden, beispielsweise indem zwei oder mehr Öffnungen an einer Chipseite vorgesehen werden, deren Phasenanpassung entsprechend aufeinander eingestellt ist, beispielsweise ein einzelnes MEMS 40.

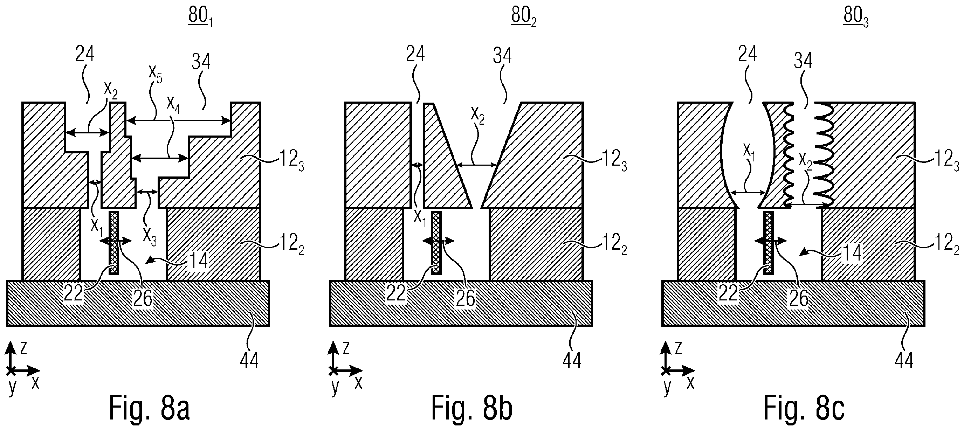

Die Fig. 8a, 8b und 8c zeigen schematische Seitenschnittansichten von MEMS 80₁, 80₂ und 80₃ gemäß hierin beschriebener Ausführungsbeispiele, die einzeln oder als Array ausgeführt sein können, wobei Kombinationen unterschiedlicher MEMS in einem Array problemlos möglich sind. Anhand der Fig. 8a, 8b und 8c wird eine Phasenanpassung der Öffnungen 24 und/oder 34 beschrieben. Zur Einstellung eines jeweiligen Phasenversatzes kann möglicherweise eine Variation der Form der Öffnungen 24 und/oder 34 ausgeführt werden. Möglicherweise kann diese entlang der Wellenausbreitungsrichtung z ausgeführt werden. So ist beispielsweise in Fig. 8a für die Öffnung 24 eine diskontinuierliche, stufenweise Anpassung einer Größe x₁, x₂ der Öffnung 24 entlang der z-Richtung gezeigt. Diese kann, beispielsweise in der Schicht 12₃, zwischen zwei Abmessungen variieren, welche sich beispielsweise mit zunehmender Entfernung von der Kavität 14 vergrößern. Eine Schrittweite von zwei bzw. eine Implementierung eines einzigen diskontinuierlichen Sprungs ist dabei lediglich beispielhaft. Eine höhere Anzahl ist ebenso möglich, wie es beispielsweise für die drei unterschiedlichen Abmessungen x₃, x₄ und x₅ für die Öffnung 34 in der Fig. 8a gezeigt ist.

Auch hier vergrößern sich die Abmessungen x₃, x₄ und x₅ mit zunehmendem Abstand von der Kavität 14, wobei dies nicht zwingend erforderlich ist.

In der Fig. 8b ist gezeigt, dass eine Veränderung einer Abmessung x₂ einer der Öffnungen 34 implementiert werden kann, während die Abmessung x₁ der Öffnung 24, die nicht notwendigerweise eine kleinere Öffnung als die Öffnung 34 sein muss, implementiert werden kann.

Optional zur Implementierung einer veränderlichen Abmessung x₂ als kontinuierliche Veränderung könnte das MEMS 80₂ auch eine diskontinuierliche Veränderung in Übereinstimmung mit der Fig. 8a mit einer oder mehrerer Stufen aufweisen. Alternativ oder zusätzlich könnte das MEMS 80₁ auch eine kontinuierliche Veränderung in der Öffnung 24 oder der Öffnung 34 aufweisen und/oder eine konstante Abmessung der Öffnung 24 und/oder 34.

In der Fig. 8c ist gezeigt, dass die Abmessung der Öffnung 24 und/oder 34 mit zunehmendem Abstand entlang der z-Richtung ausgehend von der Kavität 14 beliebig sein kann und nicht auf eine monotone oder streng monotone Zunahme beschränkt ist. So nimmt die Abmessung x₁ der Öffnung 24 nach Erreichen eines lokalen Maximums wieder ab, wenn ausgehend von der Kavität 14 entlang positiver z-Richtung eine entsprechende Betrachtung erfolgt. Dies kann auch periodisch oder aperiodisch erfolgen, wie es beispielsweise für die Öffnung 34 gezeigt ist. Es sei erwähnt, dass anstelle einer Zunahme der Abmessung x₁ ausgehend von der Kavität 14 auch eine Abnahme in dem MEMS 80₁, 80₂ und/oder 80₃ erfolgen könnte.

Das bedeutet, eine weitere Möglichkeit zur Einstellung des Phasenversatzes eines hierin beschriebenen MEMS kann durch die Variation der Form der Luftauslassöffnung in der Wellenausbreitungsrichtung erfolgen. Hierzu können ein oder mehrere Stufen vorgesehen sein, beispielsweise durch Ätzung. Alternativ oder zusätzlich können schräge Wände der Öffnungen vorgesehen sein, wie es beispielsweise für das MEMS 80₂ gezeigt ist. Alternativ oder zusätzlich können auch nicht-gerade Wände oder nicht-geneigte Wände vorgesehen sein, wie beispielsweise sogenannte Scallops oder gekrümmte Wände, wie es für das MEMS 80₃ dargestellt ist.

Obwohl die veränderliche Größe der Öffnungen 24 und/oder 34 lediglich entlang der x-Richtung beschrieben ist, kann eine entsprechende Ausgestaltung alternativ oder zusätzlich auch entlang der y-Richtung erfolgen, wobei eine entsprechende Größe unabhängig voneinander eingestellt werden kann.

Während vorangehend ein einstellbarer und konstanter Phasenversatz der Öffnungen 24 und/oder 34 beschrieben ist, sehen Ausführungsbeispiele der vorliegenden Erfindung ebenfalls vor, einen statisch oder dynamisch veränderlichen Phasenversatz bereitzustellen. Gemäß einem Ausführungsbeispiel umfasst ein MEMS und/oder ein Array hierzu eine Phasenanpassungseinrichtung, die ausgebildet ist, um ein Ansteuersignal zu empfangen, und um den Phasenversatz der Öffnung 24 und/oder den Phasenversatz der Öffnung 34 basierend auf dem Ansteuersignal anzupassen.

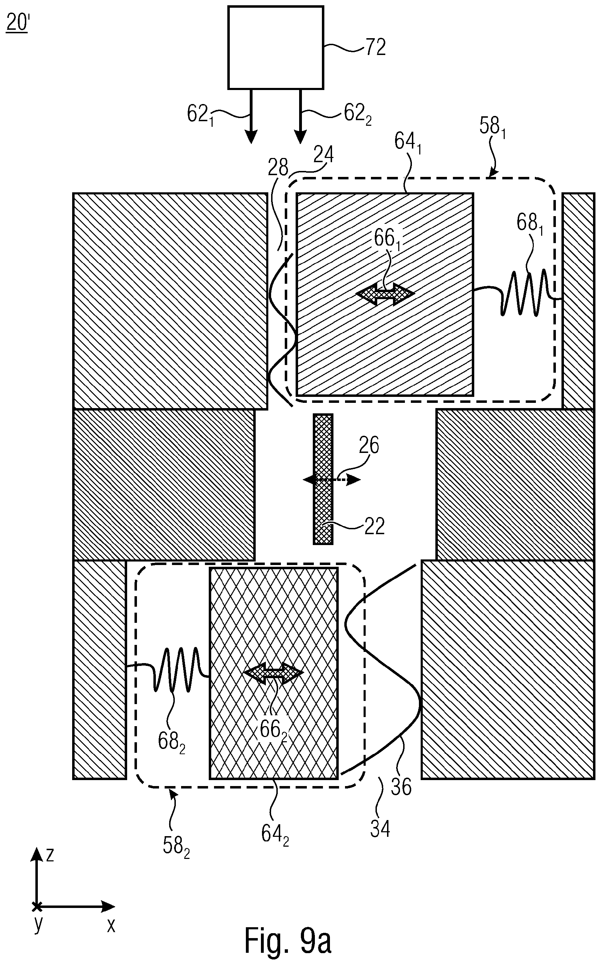

Fig. 9a zeigt hierzu eine schematische Seitenschnittansicht eines MEMS 20', das gegenüber dem MEMS 20 eine Phasenanpassungseinrichtung aufweisen kann.

Gemäß einem Ausführungsbeispiel kann das MEMS 20' eine Phasenanpassungseinrichtung 58₁ zum Anpassen einer Phasenverschiebung für die periodische Oszillation 28 umfassen und/oder kann eine Phasenanpassungseinrichtung 58₂ zum Anpassen einer Phasenverschiebung für die periodische Oszillation 36 durch die Öffnung 34 umfassen. Beispielsweise kann die Phasenanpassungseinrichtung 58₁ ein Ansteuersignal 62, empfangen und basierend hierauf die Phasenverschiebung der Öffnung 24 anpassen. Alternativ oder zusätzlich kann die Phasenanpassungseinrichtung 58₂ ausgebildet sein, um ein Ansteuersignal 62₂ zu empfangen und basierend hierauf die Phasenverschiebung der Öffnung 34 anzupassen. Die Phasenanpassungseinrichtungen 58₁ und 58₂ können jeweils unabhängig voneinander angeordnet werden oder können auch als eine gemeinsame Phasenanpassungseinrichtung angeordnet werden. Beispielsweise kann die Phasenanpassungseinrichtung 58₁ eine bewegliche Struktur 64, und/oder die Phasenanpassungseinrichtung 58₂ eine bewegliche Struktur 64₂ aufweisen, die entlang einer oder mehrerer Bewegungsrichtungen 66₁, 66₂ beweglich angeordnet sein kann, um basierend auf einer dadurch erhaltenen Bewegung die Phasenverschiebung anzupassen. Beispielsweise können Phasenanpassungseinrichtungen in Übereinstimmung mit hierin beschriebenen Ausführungsbeispielen ausgebildet sein, um eine Größe der Öffnung 24 und/oder eine Größe der Öffnung 34 zu verändern, um den Phasenversatz anzupassen. Alternativ oder zusätzlich kann die Phasenanpassungseinrichtung ausgebildet sein, um lokal im Bereich der Öffnung 24 und/oder 34 eine Temperatur und/oder eine Fluiddichte oder dergleichen zu ändern, um den Phasenversatz anzupassen. Möglicherweise weist die Phasenanpassungseinrichtung 58₁ zur Bewegung des Elements 64, und/oder zum Erzeugen anderer Effekte einen Aktuator 68₁ auf. Die Phasenanpassungseinrichtung 58₂ kann einen Aktuator 68₂ aufweisen.

In anderen Worten zeigt Fig. 9a die Erweiterung der Anordnung in Fig. 2, wo die geometrischen Abmessungen der Luftauslassöffnung durch zusätzliche Aktuatoren in dem Deckel- und/oder Bodenwafer verändert werden können. Damit kann die Richtcharakteristik aktiv gesteuert werden, ohne dass die Verdrängerelemente ein anderes Signal erhalten müssen, das bedeutet, das bewegliche Element kann möglicherweise unverändert angesteuert werden. Des Weiteren sind auf diese Weise Hauptkeulen möglich (Array-Prinzip), welche aktiv durch die Verdrängung der Luftauslassöffnungen verändert werden können. Zusätzlich kann durch die Veränderung der Geometrie die Phasenkorrektur/Phasenanpassung für einen breiten Wellenlängenbereich umgesetzt werden, was die Frequenzbandbreite der Vorrichtung gegenüber einer statischen Ausführung wesentlich vergrößern kann.

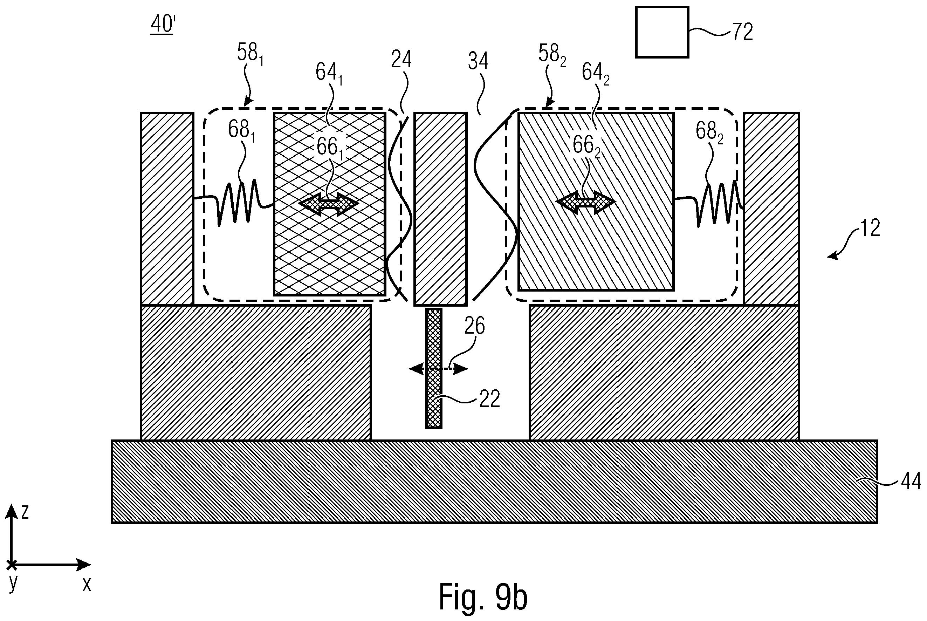

Fig. 9b zeigt eine schematische Seitenschnittansicht eines MEMS 40', das gegenüber dem MEMS 40 durch Bereitstellen einer Phasenanpassungseinrichtung 58₁ und einer Phasenanpassungseinrichtung 58₂ erweitert ist. Die Phasenanpassungseinrichtungen 58, und/oder 58₂ können dabei unabhängig voneinander implementiert werden, beispielsweise lediglich eine davon. Jede der Phasenanpassungseinrichtungen 58₁ und 58₂ kann alternativ oder zusätzlich in Übereinstimmung mit den Ausführungen zur Fig. 9a gebildet sein.

In anderen Worten zeigt Fig. 9b die Erweiterung der Anordnung in Fig. 4, wo die geometrischen Abmessungen der Luftauslassöffnungen durch zusätzliche Aktuatoren im Deckelwafer verändert werden können. Damit sind Wandler ohne Rückvolumen und mit einer aktiv steuerbaren Richtung der Hauptkeule möglich.

Eine hierin beschriebene Phasenanpassungseinrichtung kann einzeln in einem hierin beschriebenen MEMS, aber auch in einem Array umgesetzt werden. In einem Array kann eine in den Fig. 9a und 9b dargestellte Steuerungseinrichtung ausgebildet sein, um die Anpassungssignale 62, und 62₂ bereitzustellen. Wenngleich ein einzelnes MEMS ausgebildet sein kann, um ein Ansteuersignal 62₁ und/oder 62₂ von extern zu empfangen, kann es für das gesamte Array von Vorteil sein, die Steuerungseinrichtung bereits mitintegriert zu haben, auch wenn dies nicht obligatorisch ist. Die Phasenanpassungseinrichtung eines Arrays kann ausgebildet sein, um das zumindest eine Ansteuersignal zu empfangen und um zumindest einen ersten Phasenversatz einer der Öffnungen 24 und/oder zumindest einen Phasenversatz der Öffnungen 34 basierend auf dem Ansteuersignal anzupassen. Je mehr Öffnungen zur Anpassung eines Phasenversatzes eingerichtet sind, desto höher ist der Freiheitsgrad, der erhalten werden kann. Gemäß einem Ausführungsbeispiel ist die Steuerungseinrichtung ausgebildet, um den Phasenversatz der zumindest einen Öffnung 34 unabhängig von einem Phasenversatz der zumindest einen Öffnung 24 und/oder den Phasenversatz der zumindest einen Öffnung 24 unabhängig von einem Phasenversatz der zumindest einen Öffnung 34 zu steuern.

Gemäß einem Ausführungsbeispiel ist die Steuerungseinrichtung 72 ausgebildet, um die Phasenanpassungseinrichtung basierend auf dem Ansteuersignal zu steuern, um für eine Überlagerung der phasenversetzten ersten periodischen Oszillationen 32 und/oder für eine Überlagerung der phasenversetzten zweiten periodischen Oszillationen 36 zumindest eines aus einer Änderung einer Keule einer Richtcharakteristik der Überlagerung, einer Kompensation für eine breitbandige Phasenanpassung und einer Modulation eines Signals auf eine Frequenz der ersten und/oder zweiten phasenversetzten periodischen Oszillationen zu erzeugen. Die Kompensation einer breitbandigen Phasenanpassung kann zur frequenzgenauen Nachführung der Phasenanpassung genutzt werden. Beispielsweise kann für ein gern genutztes Chirp-Signal die Phasenanpassung ideal nachgeführt werden. Dies kann beispielsweise dergestalt erfolgen, dass der Phasenversatz stets genau 180° für die aktuelle Frequenz der erzeugten periodischen Oszillation beträgt.

Gemäß einem Ausführungsbeispiel umfasst eine hierin beschriebene Vorrichtung ein MEMS gemäß einem Ausführungsbeispiel und/oder ein Array gemäß einem Ausführungsbeispiel. Wie es im Zusammenhang mit hierin beschriebenen Ausführungsbeispielen erörtert ist, können dabei die unterschiedlichen Öffnungen 24 und 34 eines MEMS mit demselben fluidischen Volumen verbunden sein. Optional kann das MEMS als Lautsprecher konfiguriert sein. Dies ermöglicht, den Lautsprecher optional ohne ein separates Rückvolumen auszubilden.

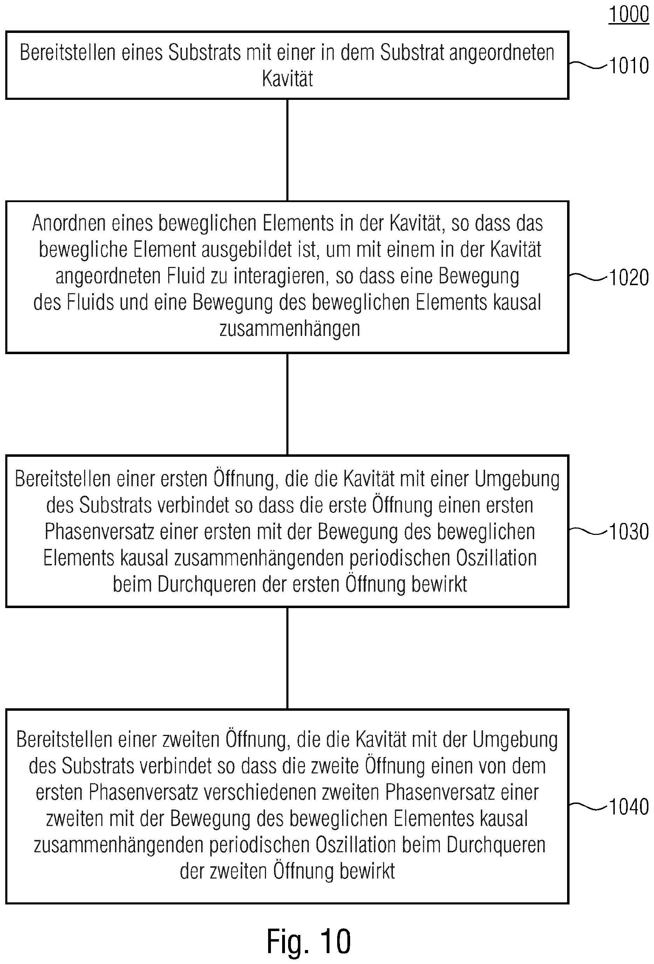

Fig. 10 zeigt ein schematisches Flussdiagramm eines Verfahrens 1000 gemäß einem Ausführungsbeispiel, das beispielsweise zum Herstellen eines hierin beschriebenen MEMS genutzt werden kann. Ein Schritt 1010 umfasst ein Bereitstellen eines Substrats mit einer in dem Substrat angeordneten Kavität.

Ein Schritt 1020 umfasst ein Anordnen eines beweglichen Elements in der Kavität, so dass das bewegliche Element ausgebildet ist, um mit einem in der Kavität angeordneten Fluid zu interagieren, so dass eine Bewegung des Fluids und eine Bewegung des beweglichen Elements kausal zusammenhängen.

Ein Schritt 1030 umfasst ein Bereitstellen einer ersten Öffnung, die die Kavität mit einer Umgebung des Substrats verbindet, so dass die erste Öffnung einen ersten Phasenversatz einer ersten mit der Bewegung des beweglichen Elements kausal zusammenhängenden periodischen Oszillation beim Durchqueren der ersten Öffnung bewirkt. Ein Schritt 1040 umfasst ein Bereitstellen einer zweiten Öffnung, die die Kavität mit der Umgebung des Substrats verbindet, so dass die zweite Öffnung einen von dem ersten Phasenversatz verschiedenen zweiten Phasenversatz einer zweiten mit der Bewegung des beweglichen Elements kausal zusammenhängenden periodischen Oszillation beim Durchqueren der zweiten Öffnung bewirkt.

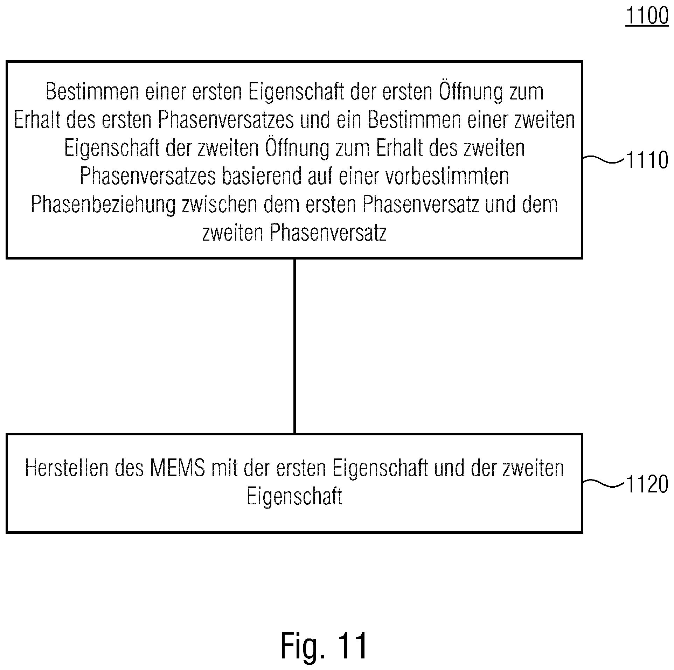

Fig. 11 zeigt ein schematisches Flussdiagramm eines Verfahrens 1100 gemäß einem Ausführungsbeispiel, das beispielsweise zum Auslegen oder Dimensionieren eines hierin beschriebenen MEMS genutzt werden kann. Das Verfahren 1100 kann möglicherweise aber nicht notwendigerweise computerimplementiert ausgeführt werden.

Ein Schritt 1110 umfasst ein Bestimmen einer ersten Eigenschaft der ersten Öffnung zum Erhalt des ersten Phasenversatzes und ein Bestimmen einer zweiten Eigenschaft einer zweiten Öffnung zum Erhalt des zweiten Phasenversatzes basierend auf einer vorbestimmten Phasenbeziehung zwischen dem ersten Phasenversatz und dem zweiten Phasenversatz.

Ein Schritt 1120 umfasst ein Herstellen des MEMS mit der ersten Eigenschaft und der zweiten Eigenschaft.

Hierin beschriebene Ausführungsbeispiele stellen MEMS-Bauelemente und diese umfassende Arrays und Vorrichtungen bereit, wobei die MEMS-Bauelemente Schichtstapel umfassen können, die zumindest aus einer Substratschicht bestehen, in der die Elektroden und die passiven Elemente angeordnet sind. Weitere Schichten betreffen einen Boden, der auch als Handlingwafer bezeichnet werden kann und einen Deckel, der auch als Deckelwafer bezeichnet wird. Sowohl Deckel- als auch Handlingwafer können über stoffschlüssige Verfahren, vorzugsweise Bonden, mit der Substratebene verbunden werden, wodurch akustisch abgedichtete Zwischenräume im Bauelement entstehen können. In diesem Zwischenraum, der der Deviceebene entspricht, verformen sich die verformbaren Bauelemente, in anderen Worten erfolgt die Verformung in-plane.

Die Schichten können beispielsweise elektrisch leitfähige Materialien aufweisen, beispielsweise dotierte Halbleitermaterialien und/oder Metallmaterialien. Die schichtweise Anordnung elektrisch leitfähiger Schichten ermöglicht eine einfache Ausgestaltung, da durch selektives Herauslösen aus der Schicht Elektroden (für auslenkbare Elemente) und passive Elemente gebildet werden können. Sofern elektrisch nicht leitfähige Werkstoffe angeordnet werden sollen, kann dies so umgesetzt werden, dass der schichtweise Auftrag dieser Werkstoffe durch Abscheideverfahren erfolgt.

Hierin beschriebene Ausführungsbeispiele lösen die Aufgabe, eine Vorrichtung zum effektiven Verdrängen eines Volumenstroms im Ultraschallbereich (akustische Welle, periodische Oszillation) mit minimalem Platzverbrauch und maximaler Leistungsnutzung zu schaffen oder anzustreben. Der Wandler/Transducer kann einen Waferstapel mit Device- und Deckelwafer umfassen. Zusätzlich kann auch ein Bodenwafer vorhanden sein. Der Devicewafer kann ein Verdrängerelement aufweisen, mit einer ersten und einer zweiten Verdrängungsrichtung, etwa im Sinne eines akustischen Dipols. Die erste und die zweite Auslassöffnung können an die Umgebung angebunden werden. Mittels unterschiedlicher Geometrie und ggf. Position der ersten und zweiten Luftauslassöffnung kann der Phasenversatz zwischen den austretenden Wellen verändert oder eingestellt werden. Damit kann eine gewünschte Einstellung der Richtcharakteristik des gesamten Wandlers/Transducers erzielt werden.

Um ein Rückvolumen zu vermeiden und die Energie von der Rückseite auf die Vorderseite zu führen, kann die Schallführung so gestaltet werden, dass beide Luftauslassöffnungen auf der Vorderseite enden. Dabei ist bevorzugt, die Schallführung so zu gestalten, dass die beiden Schallwellen bevorzugt phasengleich oder mit einem definierten Phasenversatz an der Oberfläche des Wandlers austreten. Der Phasenversatz wird bevorzugt durch die akustischen Effekte in den engen Luftauslasskanälen erzeugt, wobei der Phasenversatz der ersten und der zweiten Verdrängerseite durch die unterschiedlichen Weglängen, Positionen, Formen oder Breiten der beiden Luftauslassöffnungen zueinander eingestellt werden kann. In einem typischen Chipstapel kann es jedoch durch den Boschprozess verhindert sein, die Austrittsöffnungen, welche hier als Wellenleiter agieren, so in die Tiefe zu ätzen, dass ein beispielsweise mäanderförmiger Phasenversatz entsteht. Als Alternative können die thermoviskosen Effekte in den engen Kanälen bevorzugt verwendet werden, wobei bei unterschiedlicher Dicke der ersten und der zweiten Luftauslassöffnung ein Phasenversatz aufgrund der sich stark ändernden akustischen Eigenschaft bis zum Erreichen der Chipoberfläche erzeugt werden kann.

Ein bevorzugtes Design der Öffnung sorgt dafür, dass die Phase des Schalls von der Vorderseite und der Rückseite des Aktuators im Chip sich bis zum Erreichen der Oberfläche um 180° dreht, wobei die Summenleistung der ersten und der zweiten Verdrängerseite an einer Chipseite erhalten wird. Dadurch wird kein Rückvolumen mehr benötigt.

Ausführungsbeispiele der vorliegenden Erfindung beziehen sich auf Hardware und Vorrichtungen. Eine Vorrichtung zum Verdrängen der Luft für die Erzeugung von Schallwellen mit einer geometrisch angepassten Form und Position der Luftauslassöffnungen kann bereitgestellt werden, was dem Formen der Richtcharakteristik dient. Es können phasenverschiedene Seiten eines abstrahlenden Elementes genutzt werden und die Öffnungen können eine entsprechende Position relativ zum abstrahlenden Element aufwiesen, etwa bezogen auf das Kammervolumen zu einem Zeitpunkt mit positivem Druckvorzeichen und andersherum.

Folgende Aspekte werden durch hierin beschriebene Ausführungsbeispiele adressiert:
1. Unterschiedliche Phasenverschiebung bei unterschiedlichen Luftauslassöffnungen
2. Phasenversatz durch thermoviskosen Effekte
   2.1. Durch Variation der geometrischen Form und Position der Luftauslassöffnungen
   2.2. Erlaubt das Designen eines definierten Phasenversatzes zwischen den beiden Austrittsöffnungen
3. Zwei zu einem Verdränger gehörende Luftauslässe auf einer Seite des Chips
   3.1. Verdrängerelement mit einer ersten und einer zweiten Verdrängungsseite
   3.2. Die Schallführung der beiden Verdrängungsseiten ist unterschiedlich
4. Phasenversatz so, dass bei allen zu einem Balken gehörenden Auslässen die Phase am Ausgang gleich ist
   4.1. Rückvolumen kann vollständig entfallen
5. Phasenversatz so, dass die Phase bei den zu einem Balken gehörenden Auslässen die Ausbreitungsrichtung der Welle steuert
   5.1. Richtungscharakteristik des Wandlers kann designt werden
   5.2. Nichtsenkrechte Hauptkeulen möglich (Array-Prinzip)
6. Phasenversatz so, dass die Phase bei den zu mehreren Balken gehörenden Auslässen die Ausbreitungsrichtung der Welle steuert
   6.1. Mehr Möglichkeiten bei dem Winkeldesign
7. Phasenversatz und Lage der Auslässe so, dass die Wellenausbreitungsrichtung auf beiden Seiten des Chips unabhängig gesteuert wird
8. Aktive Phasenänderung am Auslass durch aktive Änderung der geometrischen Form der Auslassöffnung
   8.1. Aktive Steuerung der Geometrie der Auslassöffnungen
   8.2. Aktive Steuerung des Winkel der Hauptkeule, aktives Beamsteering
   8.3. Kompensation für eine breitbandige Phasenanpassung
   8.4. Modulation von Signalen auf die Trägerfrequenz
9. Phasenversatz so, dass die Welle über der Chipoberfläche auf einen oder auf mehreren Punkten fokussiert wird
10. Nutzung der AVT (Chip auf Platine) für die Nutzung als rückwärtiger / zweiter Auslass/Einlass
   10.1. Austrittsöffnungen können auch rückwärtig durch die Aufbau- und Verbindungstechnik gebildet werden
   10.2. Können ebenfalls bzgl. des Phasenversatzes designt werden. Dadurch kann auch die Platzersparnis umgesetzt werden (kein rückseitiger Wafer)
11. Einstellung eines Phasenversatzes über die Aufbau- und Verbindungstechnik (AVT), ggf. spezielle Trägerplatine (Furchen, Löcher, Kleber)
   11.1. Die Trägerplatine kann spezielle Anpassungen aufweisen, bspw. Furchen und Löcher jeweils pro Verdrängerkammer
   11.2. Der Kleber zur Verbindung zwischen Chip und Trägerplatine wird zur Kanalgestaltung eingesetzt (bspw. Füllmaterial zur Einstellung einer Kanalhöhe)
12. Weitere Einstellung des Phasenversatzes durch die Variation der Form der Luftauslassöffnung in der Wellenausbreitungsrichtung
   12.1. Eine oder mehreren Stufen, z.B. durch Ätzung
   12.2. Schräge Wände
   12.3. Nicht gerade Wände, z.B. Scallops oder gekrümmte Wände

Weitere Ausführungsformen der vorliegenden Erfindung werden nachfolgend beschrieben:
Ein erster Aspekt bezieht sich auf ein MEMS mit:
einem Substrat (12);
einer in dem Substrat (12) angeordneten Kavität (14);
zumindest einem in der Kavität (14) angeordneten beweglichen Element (22), das ausgebildet ist, um mit einem in der Kavität (14) angeordneten Fluid (16) zu interagieren, wobei eine Bewegung des Fluids (16) und eine Bewegung des beweglichen Elements (22) kausal zusammenhängen;
einer ersten Öffnung (24), die die Kavität (14) mit einer Umgebung (18) des Substrats (12) verbindet und die einen ersten Phasenversatz (ϕ₁) einer ersten mit der Bewegung des beweglichen Elements (22) kausal zusammenhängenden periodischen Oszillation beim Durchqueren der ersten Öffnung (24) bewirkt;
einer zweiten Öffnung (34), die die Kavität (14) mit der Umgebung (18) des Substrats (12) verbindet und die einen von dem ersten Phasenversatz (ϕ₁) verschiedenen zweiten Phasenversatz (ϕ₂) einer zweiten mit der Bewegung des beweglichen Elements (22) kausal zusammenhängenden periodischen Oszillation beim Durchqueren der zweiten Öffnung (34) bewirkt.

Ein zweiter Aspekt bezieht sich auf ein MEMS gemäß Aspekt 1, bei dem das bewegliche Element in-plane in einer Ebene parallel zu einer Substratebene (x/y) des Substrats (12) beweglich angeordnet ist.

Ein dritter Aspekt bezieht sich auf ein MEMS gemäß Aspekt 1 oder 2, das ausgebildet ist, um den ersten Phasenversatz (ϕ₁) und den zweiten Phasenversatz (ϕ₂) basierend auf einem thermoviskosen Effekt bereitzustellen.

Ein vierter Aspekt bezieht sich auf ein MEMS gemäß einem der vorangehenden Aspekte, bei dem sich die erste Öffnung (24) von der zweiten Öffnung (34) in zumindest einem aus
- einem Öffnungsquerschnitt der Öffnung;
- einem Verlauf des Öffnungsquerschnitts entlang einer Richtung (z) durch das Substrat (12); und
- einer Tiefe in dem Substrat (12);
unterscheidet, um einen voneinander verschiedenen Phasenversatz zu erzeugen.

Ein fünfter Aspekt bezieht sich auf ein MEMS gemäß einem der vorangehenden Aspekte, bei dem die erste Öffnung (24) und die zweite Öffnung (34) ausgebildet sind, um die erste periodische Oszillation (28) mit dem ersten Phasenversatz (ϕ₁) und die zweite periodische Oszillation (36) mit dem zweiten Phasenversatz (ϕ₂) in ein gemeinsames Volumen abzugeben, in welchem sich die erste periodische Oszillation (28) und die zweite periodische Oszillation (36) überlagern.

Ein sechster Aspekt bezieht sich auf ein MEMS gemäß einem der vorangehenden Aspekte, bei dem eine Überlagerung der ersten periodischen Oszillation (28) und der zweiten periodischen Oszillation (36) frei von einem akustischen Kurzschluss erfolgt.

Ein siebter Aspekt bezieht sich auf ein MEMS gemäß einem der vorangehenden Aspekte, bei dem die erste Öffnung (24) und die zweite Öffnung (34) an einer gleichen Seite des Substrats (12) angeordnet sind.

Ein achter Aspekt bezieht sich auf ein MEMS gemäß einem der vorangehenden Aspekte, bei dem das bewegliche Element (22) eine erste Seite (22A) und eine gegenüberliegende zweite Seite (22B) aufweist, wobei das bewegliche Element (22) ausgebildet ist, um bei einer mit der Bewegung des beweglichen Elements (22) assoziierten Verdrängung des Fluids (16) mit der ersten Seite die erste periodische Oszillation (28) zu erzeugen und das Fluid (16) durch die erste Öffnung (24) zu bewegen; und um bei einer mit der Bewegung des beweglichen Elements (22) assoziierten Verdrängung des Fluids (16) mit der zweiten Seite (22B) die zweite periodische Oszillation (36) zu erzeugen und das Fluid (16) durch die zweite Öffnung (34) zu bewegen.

Ein neunter Aspekt bezieht sich auf ein MEMS gemäß Aspekt 8, bei dem eine Schallführung mit der ersten Seite (22A) durch die erste Öffnung (24) von einer Schallführung mit der zweiten Seite (22B) durch die zweite Öffnung (34) basierend auf dem ersten Phasenversatz (ϕ₁) und dem zweiten Phasenversatz (ϕ₂) voneinander verschieden ist.

Ein zehnter Aspekt bezieht sich auf ein MEMS gemäß einem der Aspekte 1 bis 9, bei dem der erste Phasenversatz (ϕ₁) eine erste Korrelation zu der Bewegung des beweglichen Elements (22) aufweist; und der zweite Phasenversatz (ϕ₂) eine zweite Korrelation zu der Bewegung des beweglichen Elements (22) aufweist; wobei der erste Phasenversatz (ϕ₁) und der zweite Phasenversatz (ϕ₂) eine Beziehung zu einander aufweisen, um die erste periodische Oszillation (28) mit dem ersten Phasenversatz (ϕ₁) und die zweite periodische Oszillation (36) mit dem zweiten Phasenversatz (ϕ₂) mit einer innerhalb eines Toleranzbereichs übereinstimmenden Phase in die Umgebung (18) abzugeben.

Ein elfter Aspekt bezieht sich auf ein MEMS gemäß einem der Aspekte 1 bis 9, bei dem der erste Phasenversatz (ϕ₁) eine erste Korrelation zu der Bewegung des beweglichen Elements (22) aufweist; und der zweite Phasenversatz (ϕ₂) eine zweite Korrelation zu der Bewegung des beweglichen Elements (22) aufweist; wobei der erste Phasenversatz (ϕ₁) und der zweite Phasenversatz (ϕ₂) eine Beziehung zu einander aufweisen, um die erste periodische Oszillation (28) mit dem ersten Phasenversatz (ϕ₁) und die zweite periodische Oszillation (36) mit dem zweiten Phasenversatz (ϕ₂) mit einer durch eine Überlagerung der ersten periodischen Oszillation (28) und der zweiten periodischen Oszillation (36) (28) erhaltene Richtcharakteristik in die Umgebung (18) abzugeben.

Ein zwölfter Aspekt bezieht sich auf ein MEMS gemäß Aspekt 11, bei der die Richtcharakteristik bezogen auf eine Oberflächennormale (54) des Substrats (12) und eine Richtung der ersten Öffnung (24) und/oder der zweiten Öffnung (34) schräg angeordnet ist.

Ein dreizehnter Aspekt bezieht sich auf ein MEMS gemäß einem der vorangehenden Aspekte mit einer Phasenanpassungseinrichtung (58), die ausgebildet ist, um ein Ansteuersignal (62) zu empfangen und um den ersten Phasenversatz (ϕ₁) und/oder den zweiten Phasenversatz (ϕ₂) basierend auf dem Ansteuersignal (62) anzupassen.

Ein vierzehnter Aspekt bezieht sich auf ein MEMS gemäß Aspekt 13, bei dem die Phasenanpassungseinrichtung (58) ausgebildet ist, um eine Größe der ersten Öffnung (24) zu verändern, um den ersten Phasenversatz (ϕ₁) anzupassen; und/oder um eine Größe der zweiten Öffnung (34) zu verändern, um den zweiten Phasenversatz (ϕ₂) anzupassen.

Ein fünfzehnter Aspekt bezieht sich auf ein MEMS gemäß einem der vorangehenden Aspekte, bei dem die erste periodische Oszillation eine erste Schallwelle, eine erste Ultraschallwelle und/oder eine erste akustische Welle umfasst; und/oder bei dem die zweite periodische Oszillation eine zweite Schallwelle, eine zweite Ultraschallwelle und/oder eine zweite akustische Welle umfasst.

Ein sechzehnter Aspekt bezieht sich auf ein MEMS gemäß einem der vorangehenden Aspekte, bei dem das bewegliche Element ausgebildet ist, um mit der Bewegung die erste periodische Oszillation und die zweite periodische Oszillation phasenverschieden zu erzeugen.

Ein siebzehnter Aspekt bezieht sich auf ein Array umfassend eine Mehrzahl von MEMS gemäß einem der vorangehenden Aspekte.

Ein achtzehnter Aspekt bezieht sich auf ein Array gemäß Aspekt 17, das ausgebildet ist, um die ersten phasenversetzten periodischen Oszillationen mit einer gemeinsamen Richtcharakteristik auszusenden und/oder um die zweiten phasenversetzten periodischen Oszillationen mit einer gemeinsamen Richtcharakteristik auszusenden.

Ein neunzehnter Aspekt bezieht sich auf ein Array gemäß Aspekt 18, das ausgebildet ist, um die ersten phasenversetzten periodischen Oszillationen mit einer gemeinsamen Richtcharakteristik auszusenden, die bezogen auf eine Oberflächennormale (54) des Substrats (12) und eine Richtung der ersten Öffnungen (24, 24', 24", 24‴) der Mehrzahl von MEMS schräg angeordnet ist und bei dem die ersten Öffnungen (24, 24', 24", 24‴) der Mehrzahl von MEMS für einen voneinander verschiedenen Phasenversatz eingerichtet sind; und/oder
das ausgebildet ist, um die zweiten phasenversetzten periodischen Oszillationen mit einer gemeinsamen Richtcharakteristik auszusenden, die bezogen auf eine Oberflächennormale (54) des Substrats (12) und eine Richtung der zweiten Öffnungen (34, 34', 34", 34‴) der Mehrzahl von MEMS schräg angeordnet ist und bei dem die zweiten Öffnungen der Mehrzahl von MEMS für einen voneinander verschiedenen Phasenversatz eingerichtet sind.

Ein zwanzigster Aspekt bezieht sich auf ein Array gemäß einem der Aspekte 17 bis 19, bei dem die Mehrzahl an ersten Öffnungen (24, 24', 24", 24‴) einen jeweiligen Phasenversatz der ersten periodischen Oszillationen bereitstellen und eine Überlagerung der phasenversetzten ersten periodischen Oszillationen auf einen gemeinsamen ersten Fokusbereich (56) gerichtet ist; und/oder bei dem die Mehrzahl an zweiten Öffnungen (34, 34', 34", 34‴) einen jeweiligen Phasenversatz der zweiten periodischen Oszillationen bereitstellen und eine Überlagerung phasenversetzter zweiter periodischer Oszillationen auf einen gemeinsamen zweiten Fokusbereich gerichtet ist.

Ein einundzwanzigster Aspekt bezieht sich auf ein Array gemäß Aspekt 20, bei dem der erste Fokusbereich (56) und der zweite Fokusbereich räumlich benachbart oder überlappend sind.

Ein zweiundzwanzigster Aspekt bezieht sich auf ein Array gemäß einem der Aspekte 17 bis 21, mit einer Steuerungseinrichtung (72), die ausgebildet ist, um ein Ansteuersignal (62) bereitzustellen; und
einer Phasenanpassungseinrichtung (58), die ausgebildet ist, um das Ansteuersignal (62) zu empfangen und um zumindest einen ersten Phasenversatz zumindest einer der ersten Öffnungen (24, 24', 24", 24‴) und/oder zumindest einen zweiten Phasenversatz zumindest einer der zweiten Öffnungen (34, 34', 34", 34‴) basierend auf dem Ansteuersignal anzupassen.

Ein dreiundzwanzigster Aspekt bezieht sich auf ein Array gemäß Aspekt 22, bei dem die Steuerungseinrichtung (72) ausgebildet ist, um den Phasenversatz der zumindest einen der zweiten Öffnungen (34, 34', 34", 34‴) unabhängig von einem Phasenversatz der zumindest einen der ersten Öffnungen (24, 24', 24", 24‴) und/oder um den Phasenversatz der zumindest einen der ersten Öffnungen (24, 24', 24", 24‴) unabhängig von einem Phasenversatz der zumindest einen der zweiten Öffnungen (34, 34`, 34", 34‴) zu steuern.

Ein vierundzwanzigster Aspekt bezieht sich auf ein Array gemäß Aspekt 22 oder 23, bei dem die Steuerungseinrichtung (72) ausgebildet ist, um die Phasenanpassungseinrichtung (58) basierend auf dem Ansteuersignal (62) zu steuern, um für eine Überlagerung der phasenversetzten ersten periodischen Oszillationen und/oder für eine Überlagerung der phasenversetzten zweiten periodischen Oszillationen zumindest eines aus:
- einer Änderung einer Keule einer Richtcharakteristik der Überlagerung;
- einer Kompensation für eine breitbandige Phasenanpassung
- einer Modulation eines Signals auf eine Frequenz der ersten und/oder zweiten phasenversetzten periodischen Oszillationen
zu erzeugen.

Ein fünfundzwanzigster Aspekt bezieht sich auf eine Vorrichtung mit:
einem MEMS gemäß einem der Aspekte 1 bis 16; oder
einem Array gemäß einem der Aspekte 17 bis 24,
wobei die erste Öffnung (24) und die zweite Öffnung (34) des MEMS mit demselben fluidischen Volumen verbunden sind.

Ein sechsundzwanzigster Aspekt bezieht sich auf eine Vorrichtung gemäß Aspekt 25, bei der das MEMS als Lautsprecher konfiguriert ist und ohne Rückvolumen ausgebildet ist.

Ein siebenundzwanzigster Aspekt bezieht sich auf eine Vorrichtung gemäß Aspekt 25 oder 26, die für eine Überlagerung der ersten periodischen Oszillation und der zweiten periodischen Oszillation in einem gemeinsamen Volumen eingerichtet ist, und die Überlagerung frei von einem akustischen Kurzschluss ist.

Ein achtundzwanzigster Aspekt bezieht sich auf ein Verfahren (1000) zum Herstellen eines MEMS mit:
Bereitstellen (1010) eines Substrats mit einer in dem Substrat angeordneten Kavität;
Anordnen (1020) zumindest eines beweglichen Elements in der Kavität, so dass das bewegliche Element ausgebildet ist, um mit einem in der Kavität angeordneten Fluid zu interagieren, so dass eine Bewegung des Fluids und eine Bewegung des beweglichen Elements kausal zusammenhängen;
Bereitstellen (1030) einer ersten Öffnung, die die Kavität mit einer Umgebung des Substrats verbindet so dass die erste Öffnung einen ersten Phasenversatz einer ersten mit der Bewegung des beweglichen Elements kausal zusammenhängenden periodischen Oszillation beim Durchqueren der ersten Öffnung bewirkt; und

Bereitstellen (1040) einer zweiten Öffnung, die die Kavität mit der Umgebung des Substrats verbindet so dass die zweite Öffnung einen von dem ersten Phasenversatz verschiedenen zweiten Phasenversatz einer zweiten mit der Bewegung des beweglichen Elementes kausal zusammenhängenden periodischen Oszillation beim Durchqueren der zweiten Öffnung bewirkt.

Ein neunundzwanzigster Aspekt bezieht sich auf ein Verfahren (1100) zum Auslegen eines MEMS gemäß Anspruch 1 mit folgenden Schritten:
Bestimmen (1110) einer ersten Eigenschaft der ersten Öffnung zum Erhalt des ersten Phasenversatzes und Bestimmen einer zweiten Eigenschaft der zweiten Öffnung zum Erhalt des zweiten Phasenversatzes basierend auf einer vorbestimmten Phasenbeziehung zwischen dem ersten Phasenversatz und dem zweiten Phasenversatz; und
Herstellen (1120) des MEMS mit der ersten Eigenschaft und der zweiten Eigenschaft.

Obwohl manche Aspekte im Zusammenhang mit einer Vorrichtung beschrieben wurden, versteht es sich, dass diese Aspekte auch eine Beschreibung des entsprechenden Verfahrens darstellen, sodass ein Block oder ein Bauelement einer Vorrichtung auch als ein entsprechender Verfahrensschritt oder als ein Merkmal eines Verfahrensschrittes zu verstehen ist. Analog dazu stellen Aspekte, die im Zusammenhang mit einem oder als ein Verfahrensschritt beschrieben wurden, auch eine Beschreibung eines entsprechenden Blocks oder Details oder Merkmals einer entsprechenden Vorrichtung dar.

Je nach bestimmten Implementierungsanforderungen können Ausführungsbeispiele der Erfindung in Hardware oder in Software implementiert sein. Die Implementierung kann unter Verwendung eines digitalen Speichermediums, beispielsweise einer Floppy-Disk, einer DVD, einer Blu-ray Disc, einer CD, eines ROM, eines PROM, eines EPROM, eines EEPROM oder eines FLASH-Speichers, einer Festplatte oder eines anderen magnetischen oder optischen Speichers durchgeführt werden, auf dem elektronisch lesbare Steuersignale gespeichert sind, die mit einem programmierbaren Computersystem derart zusammenwirken können oder zusammenwirken, dass das jeweilige Verfahren durchgeführt wird. Deshalb kann das digitale Speichermedium computerlesbar sein. Manche Ausführungsbeispiele gemäß der Erfindung umfassen also einen Datenträger, der elektronisch lesbare Steuersignale aufweist, die in der Lage sind, mit einem programmierbaren Computersystem derart zusammenzuwirken, dass eines der hierin beschriebenen Verfahren durchgeführt wird.

Allgemein können Ausführungsbeispiele der vorliegenden Erfindung als Computerprogrammprodukt mit einem Programmcode implementiert sein, wobei der Programmcode dahin gehend wirksam ist, eines der Verfahren durchzuführen, wenn das Computerprogrammprodukt auf einem Computer abläuft. Der Programmcode kann beispielsweise auch auf einem maschinenlesbaren Träger gespeichert sein.

Andere Ausführungsbeispiele umfassen das Computerprogramm zum Durchführen eines der hierin beschriebenen Verfahren, wobei das Computerprogramm auf einem maschinenlesbaren Träger gespeichert ist.

Mit anderen Worten ist ein Ausführungsbeispiel des erfindungsgemäßen Verfahrens somit ein Computerprogramm, das einen Programmcode zum Durchführen eines der hierin beschriebenen Verfahren aufweist, wenn das Computerprogramm auf einem Computer abläuft. Ein weiteres Ausführungsbeispiel der erfindungsgemäßen Verfahren ist somit ein Datenträger (oder ein digitales Speichermedium oder ein computerlesbares Medium), auf dem das Computerprogramm zum Durchführen eines der hierin beschriebenen Verfahren aufgezeichnet ist.

Ein weiteres Ausführungsbeispiel des erfindungsgemäßen Verfahrens ist somit ein Datenstrom oder eine Sequenz von Signalen, der bzw. die das Computerprogramm zum Durchführen eines der hierin beschriebenen Verfahren darstellt bzw. darstellen. Der Datenstrom oder die Sequenz von Signalen kann bzw. können beispielsweise dahin gehend konfiguriert sein, über eine Datenkommunikationsverbindung, beispielsweise über das Internet, transferiert zu werden.

Ein weiteres Ausführungsbeispiel umfasst eine Verarbeitungseinrichtung, beispielsweise einen Computer oder ein programmierbares Logikbauelement, die dahin gehend konfiguriert oder angepasst ist, eines der hierin beschriebenen Verfahren durchzuführen.

Ein weiteres Ausführungsbeispiel umfasst einen Computer, auf dem das Computerprogramm zum Durchführen eines der hierin beschriebenen Verfahren installiert ist.

Bei manchen Ausführungsbeispielen kann ein programmierbares Logikbauelement (beispielsweise ein feldprogrammierbares Gatterarray, ein FPGA) dazu verwendet werden, manche oder alle Funktionalitäten der hierin beschriebenen Verfahren durchzuführen. Bei manchen Ausführungsbeispielen kann ein feldprogrammierbares Gatterarray mit einem Mikroprozessor zusammenwirken, um eines der hierin beschriebenen Verfahren durchzuführen. Allgemein werden die Verfahren bei einigen Ausführungsbeispielen seitens einer beliebigen Hardwarevorrichtung durchgeführt. Diese kann eine universell einsetzbare Hardware wie ein Computerprozessor (CPU) sein oder für das Verfahren spezifische Hardware, wie beispielsweise ein ASIC.

Die oben beschriebenen Ausführungsbeispiele stellen lediglich eine Veranschaulichung der Prinzipien der vorliegenden Erfindung dar. Es versteht sich, dass Modifikationen und Variationen der hierin beschriebenen Anordnungen und Einzelheiten anderen Fachleuten einleuchten werden. Deshalb ist beabsichtigt, dass die Erfindung lediglich durch den Schutzumfang der nachstehenden Patentansprüche und nicht durch die spezifischen Einzelheiten, die anhand der Beschreibung und der Erläuterung der Ausführungsbeispiele hierin präsentiert wurden, beschränkt sei.

## Patentansprüche

1. MEMS mit:
einem Substrat (12);
einer in dem Substrat (12) angeordneten Kavität (14);
zumindest einem in der Kavität (14) angeordneten beweglichen Element (22), das ausgebildet ist, um mit einem in der Kavität (14) angeordneten Fluid (16) zu interagieren, wobei eine Bewegung des Fluids (16) und eine Bewegung des beweglichen Elements (22) kausal zusammenhängen;
einer ersten Öffnung (24), die die Kavität (14) mit einer Umgebung (18) des Substrats (12) verbindet und die einen ersten Phasenversatz (ϕ₁) einer ersten mit der Bewegung des beweglichen Elements (22) kausal zusammenhängenden periodischen Oszillation beim Durchqueren der ersten Öffnung (24) bewirkt;
einer zweiten Öffnung (34), die die Kavität (14) mit der Umgebung (18) des Substrats (12) verbindet und die einen von dem ersten Phasenversatz (ϕ₁) verschiedenen zweiten Phasenversatz (ϕ₂) einer zweiten mit der Bewegung des beweglichen Elements (22) kausal zusammenhängenden periodischen Oszillation beim Durchqueren der zweiten Öffnung (34) bewirkt.

2. MEMS gemäß Anspruch 1, bei dem das bewegliche Element in-plane in einer Ebene parallel zu einer Substratebene (x/y) des Substrats (12) beweglich angeordnet ist.

3. MEMS gemäß Anspruch 1 oder 2, bei dem die erste Öffnung (24) und die zweite Öffnung (34) ausgebildet sind, um die erste periodische Oszillation (28) mit dem ersten Phasenversatz (ϕ₁) und die zweite periodische Oszillation (36) mit dem zweiten Phasenversatz (ϕ₂) in ein gemeinsames Volumen abzugeben, in welchem sich die erste periodische Oszillation (28) und die zweite periodische Oszillation (36) überlagern.

4. MEMS gemäß einem der vorangehenden Ansprüche, bei dem die erste Öffnung (24) und die zweite Öffnung (34) an einer gleichen Seite des Substrats (12) angeordnet sind.

5. MEMS gemäß einem der vorangehenden Ansprüche, bei dem das bewegliche Element (22) eine erste Seite (22A) und eine gegenüberliegende zweite Seite (22B) aufweist, wobei das bewegliche Element (22) ausgebildet ist, um bei einer mit der Bewegung des beweglichen Elements (22) assoziierten Verdrängung des Fluids (16) mit der ersten Seite die erste periodische Oszillation (28) zu erzeugen und das Fluid (16) durch die erste Öffnung (24) zu bewegen; und um bei einer mit der Bewegung des beweglichen Elements (22) assoziierten Verdrängung des Fluids (16) mit der zweiten Seite (22B) die zweite periodische Oszillation (36) zu erzeugen und das Fluid (16) durch die zweite Öffnung (34) zu bewegen.

6. MEMS gemäß Anspruch 5, bei dem eine Schallführung mit der ersten Seite (22A) durch die erste Öffnung (24) von einer Schallführung mit der zweiten Seite (22B) durch die zweite Öffnung (34) basierend auf dem ersten Phasenversatz (ϕ₁) und dem zweiten Phasenversatz (ϕ₂) voneinander verschieden ist.

7. MEMS gemäß einem der Ansprüche 1 bis 6, bei dem der erste Phasenversatz (ϕ₁) eine erste Korrelation zu der Bewegung des beweglichen Elements (22) aufweist; und der zweite Phasenversatz (ϕ₂) eine zweite Korrelation zu der Bewegung des beweglichen Elements (22) aufweist; wobei der erste Phasenversatz (ϕ₁) und der zweite Phasenversatz (ϕ₂) eine Beziehung zu einander aufweisen, um die erste periodische Oszillation (28) mit dem ersten Phasenversatz (ϕ₁) und die zweite periodische Oszillation (36) mit dem zweiten Phasenversatz (ϕ₂) mit einer innerhalb eines Toleranzbereichs übereinstimmenden Phase in die Umgebung (18) abzugeben; oder
bei dem der erste Phasenversatz (ϕ₁) eine erste Korrelation zu der Bewegung des beweglichen Elements (22) aufweist; und der zweite Phasenversatz (ϕ₂) eine zweite Korrelation zu der Bewegung des beweglichen Elements (22) aufweist; wobei der erste Phasenversatz (ϕ₁) und der zweite Phasenversatz (ϕ₂) eine Beziehung zu einander aufweisen, um die erste periodische Oszillation (28) mit dem ersten Phasenversatz (ϕ₁) und die zweite periodische Oszillation (36) mit dem zweiten Phasenversatz (ϕ₂) mit einer durch eine Überlagerung der ersten periodischen Oszillation (28) und der zweiten periodischen Oszillation (36) (28) erhaltene Richtcharakteristik in die Umgebung (18) abzugeben.

8. MEMS gemäß Anspruch 7, bei dem der erste Phasenversatz (ϕ₁) eine erste Korrelation zu der Bewegung des beweglichen Elements (22) aufweist; und der zweite Phasenversatz (ϕ₂) eine zweite Korrelation zu der Bewegung des beweglichen Elements (22) aufweist; wobei der erste Phasenversatz (ϕ₁) und der zweite Phasenversatz (ϕ₂) eine Beziehung zu einander aufweisen, um die erste periodische Oszillation (28) mit dem ersten Phasenversatz (ϕ₁) und die zweite periodische Oszillation (36) mit dem zweiten Phasenversatz (ϕ₂) mit einer durch eine Überlagerung der ersten periodischen Oszillation (28) und der zweiten periodischen Oszillation (36) (28) erhaltene Richtcharakteristik in die Umgebung (18) abzugeben; und bei der die Richtcharakteristik bezogen auf eine Oberflächennormale (54) des Substrats (12) und eine Richtung der ersten Öffnung (24) und/oder der zweiten Öffnung (34) schräg angeordnet ist.

9. MEMS gemäß einem der vorangehenden Ansprüche mit einer Phasenanpassungseinrichtung (58), die ausgebildet ist, um ein Ansteuersignal (62) zu empfangen und um den ersten Phasenversatz (ϕ₁) und/oder den zweiten Phasenversatz (ϕ₂) basierend auf dem Ansteuersignal (62) anzupassen.

10. Array umfassend eine Mehrzahl von MEMS gemäß einem der vorangehenden Ansprüche;
· wobei das Array ausgebildet ist, um die ersten phasenversetzten periodischen Oszillationen mit einer gemeinsamen Richtcharakteristik auszusenden und/oder um die zweiten phasenversetzten periodischen Oszillationen mit einer gemeinsamen Richtcharakteristik auszusenden.

11. Array gemäß Anspruch 10, das ausgebildet ist, um die ersten phasenversetzten periodischen Oszillationen mit einer gemeinsamen Richtcharakteristik auszusenden, die bezogen auf eine Oberflächennormale (54) des Substrats (12) und eine Richtung der ersten Öffnungen (24, 24', 24", 24‴) der Mehrzahl von MEMS schräg angeordnet ist und bei dem die ersten Öffnungen (24, 24', 24", 24‴) der Mehrzahl von MEMS für einen voneinander verschiedenen Phasenversatz eingerichtet sind; und/oder das ausgebildet ist, um die zweiten phasenversetzten periodischen Oszillationen mit einer gemeinsamen Richtcharakteristik auszusenden, die bezogen auf eine Oberflächennormale (54) des Substrats (12) und eine Richtung der zweiten Öffnungen (34, 34`, 34", 34‴) der Mehrzahl von MEMS schräg angeordnet ist und bei dem die zweiten Öffnungen der Mehrzahl von MEMS für einen voneinander verschiedenen Phasenversatz eingerichtet sind.

12. Array gemäß Anspruch 10 oder 11, bei dem die Mehrzahl an ersten Öffnungen (24, 24', 24", 24‴) einen jeweiligen Phasenversatz der ersten periodischen Oszillationen bereitstellen und eine Überlagerung der phasenversetzten ersten periodischen Oszillationen auf einen gemeinsamen ersten Fokusbereich (56) gerichtet ist; und/oder bei dem die Mehrzahl an zweiten Öffnungen (34, 34', 34", 34‴) einen jeweiligen Phasenversatz der zweiten periodischen Oszillationen bereitstellen und eine Überlagerung phasenversetzter zweiter periodischer Oszillationen auf einen gemeinsamen zweiten Fokusbereich gerichtet ist.

13. Array gemäß einem der Ansprüche 10 bis 12, mit einer Steuerungseinrichtung (72), die ausgebildet ist, um ein Ansteuersignal (62) bereitzustellen; und
einer Phasenanpassungseinrichtung (58), die ausgebildet ist, um das Ansteuersignal (62) zu empfangen und um zumindest einen ersten Phasenversatz zumindest einer der ersten Öffnungen (24, 24', 24", 24‴) und/oder zumindest einen zweiten Phasenversatz zumindest einer der zweiten Öffnungen (34, 34', 34", 34‴) basierend auf dem Ansteuersignal anzupassen.

14. Vorrichtung mit:
einem MEMS gemäß einem der Ansprüche 1 bis 9; oder
einem Array gemäß einem der Ansprüche 10 bis 13,
wobei die erste Öffnung (24) und die zweite Öffnung (34) des MEMS mit demselben fluidischen Volumen verbunden sind; wobei
das MEMS als Lautsprecher konfiguriert ist und ohne Rückvolumen ausgebildet ist.

15. Verfahren (1100) zum Auslegen eines MEMS gemäß Anspruch 1 mit folgenden Schritten:
Bestimmen (1110) einer ersten Eigenschaft der ersten Öffnung zum Erhalt des ersten Phasenversatzes und Bestimmen einer zweiten Eigenschaft der zweiten Öffnung zum Erhalt des zweiten Phasenversatzes basierend auf einer vorbestimmten Phasenbeziehung zwischen dem ersten Phasenversatz und dem zweiten Phasenversatz; und
Herstellen (1120) des MEMS mit der ersten Eigenschaft und der zweiten Eigenschaft.
